(19)

**Europäisches Patentamt**
**European Patent Office**
**Office européen des brevets**

(11) **EP 2 304 365 B1**

(12) **EUROPÄISCHE PATENTSCHRIFT**

(45) Veröffentlichungstag und Bekanntmachung des Hinweises auf die Patenterteilung:
**17.04.2013 Patentblatt 2013/16**

(21) Anmeldenummer: **09769289.1**

(22) Anmeldetag: **24.06.2009**

(51) Int Cl.:
*F27D 1/00* (2006.01)     *F16L 59/02* (2006.01)
*C30B 11/00* (2006.01)     *C30B 28/06* (2006.01)
*C30B 29/06* (2006.01)

(86) Internationale Anmeldenummer:
**PCT/EP2009/057901**

(87) Internationale Veröffentlichungsnummer:
**WO 2009/156440 (30.12.2009 Gazette 2009/53)**

(54) **WÄRMEISOLATIONSANORDNUNG MIT VARIABLEM WÄRMEISOLATIONSVERMÖGEN UND DEREN VERWENDUNG SOWIE VORRICHTUNG UND VERFAHREN ZUR HERSTELLUNG VON EIN- ODER MULTIKRISTALLINEN ODER GLASIGEN MATERIALIEN**

THERMAL INSULATION SYSTEM HAVING VARIABLE THERMAL INSULATING CAPACITY AND THE USE THEREOF, AND APPARATUS AND METHOD FOR PRODUCING MONOCRYSTALLINE OR MULTICRYSTALLINE OR VITREOUS MATERIALS

SYSTÈME D'ISOLATION THERMIQUE À CAPACITÉ VARIABLE D'ISOLATION THERMIQUE, SON UTILISATION ET DISPOSITIF ET PROCÉDÉ DE FABRICATION DE MATÉRIAUX MONOCRISTALLINS, POLYCRISTALLINS OU AMORPHES

(84) Benannte Vertragsstaaten:
**AT BE BG CH CY CZ DE DK EE ES FI FR GB GR HR HU IE IS IT LI LT LU LV MC MK MT NL NO PL PT RO SE SI SK TR**

(30) Priorität: **26.06.2008 DE 102008029951**

(43) Veröffentlichungstag der Anmeldung:
**06.04.2011 Patentblatt 2011/14**

(73) Patentinhaber:
• **SCHOTT AG**
  **55122 Mainz (DE)**
• **SCHOTT Solar AG**
  **55122 Mainz (DE)**

(72) Erfinder:
• **BÜLLESFELD, Frank**
  **65830 Kriftel (DE)**

• **TITTEL, Andreas**
  **06628 Bad Kösen (DE)**
• **SAHR, Uwe**
  **90411 Nürnberg (DE)**

(74) Vertreter: **2K Patentanwälte Blasberg Kewitz & Reichel**
**Partnerschaft**
**Corneliusstraße 18**
**60325 Frankfurt a. M. (DE)**

(56) Entgegenhaltungen:
**DE-A1-102005 014 051     DE-A1-102006 017 621**
**DE-U1- 29 715 846     US-A- 3 637 912**
**US-A- 5 849 080**

**Beschreibung**

**Gebiet der Erfindung**

Die vorliegende Erfindung betrifft insbesondere eine Wärmeisolationsanordnung mit einem variablen Wärmeisolationsvermögen, beispielsweise zur Verwendung zur selektiven Wärmeabfuhr am Boden eines Schmelztiegels bei der Herstellung von ein- oder multikristallinen Materialien, insbesondere von Silizium nach dem Vertical-Gradient-Freeze-Verfahren (nachfolgend auch VGF-Verfahren), beispielsweise für Anwendungen in der Photovoltaik.

**Hintergrund der Erfindung**

Allen bekannten Herstellungsverfahren, bei denen eine große Menge schmelzflüssigen Siliziums gerichtet erstarrt, ist gemeinsam, dass der Kristallschmelze an ihrem Boden Wärme entzogen wird und so ein Kristall von unten nach oben wächst. Aufgrund der typischerweise schnell verlaufenden Erstarrung und des Verzichts auf einen Keimkristall wächst der Kristall multikristallin. Es entsteht so ein Block, der aus vielen Kristallkörner besteht, von denen ein jedes Korn in der Richtung des lokal vorherrschenden Temperaturgradienten wächst. Die Anzahl von Kristallbaufehlern lässt sich nur durch Einstellen eines Temperaturgradienten mit Isothermen, die eben und exakt horizontal, d.h. parallel zum Boden des Schmelztiegels verlaufen, reduzieren.

Zur Einstellung eines solchen Temperaturgradienten ist aus dem Stand der Technik eine Wärmeisolationsanordnung bekannt, bei der eine Bodenplatte in einer ersten Stellung in Anlage oder unmittelbare Nähe zum Boden des Schmelztiegels bzw. einer diesen abstützenden Tiegelaufstellplatte gebracht wird und in einer zweiten Stellung auf einen vorbestimmten Abstand abgesenkt wird, wie beispielsweise in WO 2007/148988 A1, US 5,849,080 und DE 10 2006 017 621 A1 der Anmelderin offenbart. Während in der ersten Stellung vergleichsweise viel Wärme über den Boden des Schmelztiegels abgeführt werden kann, ist das Wärmeisolationsvermögen in der zweiten, abgesenkten Stellung der Bodenplatte höher, sodass insgesamt eine Wärmeisolationsanordnung mit einem variablem Wärmeisolationsvermögen ausgebildet ist. Bei einem solchen Aufbau kann die Bodenplatte mittels eines Kühlmittelflusses gekühlt werden.

Als Alternative zur vorstehend beschriebenen Höhenverstellung einer Kühlplatte ist aus dem Stand der Technik auch bekannt, einen Schieber, der zwischen der Unterseite des Schmelztiegels und einer vertikal darunter befindlichen Kühlplatte angeordnet ist, seitlich zu verschieben, wie beispielsweise in DE 198 55 061 A1 und DE 100 21 585 C1 offenbart. Allerdings bedingt dies einen erheblich größeren Flächenbedarf der Kristallziehanlage.

Für eine genauere Einstellung der Wärmeabfuhr vom Boden eines Schmelztiegels ist aus dem Stand der Technik auch eine Wärme leitende Struktur bekannt, die aus zwei kammartig ineinander greifenden Wärmeleitkörpern mit einer Mehrzahl von zueinander beabstandeten Wärmeleitfingern bekannt, deren Eingriff miteinander variiert werden kann, wie beispielsweise in EP 0 996 516 B1 offenbart. Die Wärmeleit- bzw. Kühlstruktur kann dabei in einer Gasatmosphäre mit variablem Druck angeordnet sein, sodass durch Absenken des Gasdrucks die Abführung von Wärme noch feinfühliger geregelt werden kann.

Untersuchungen der Erfinder an Kristallisationsanlagen mit einer höhenverstellbaren Kühlplatte haben jedoch gezeigt, dass ein Absenken der Kühlplatte alleine nicht ausreichend ist, um die Wärmeabfuhr durch die Kühlplatten so zu minimieren, dass ein effizientes Aufschmelzen des Materials in dem Schmelztiegel möglich ist. Dies gelingt nur, wenn der Wärmedurchgang durch die Kühlplatten mit einer zusätzlichen Isolierung, beispielsweise aus Graphit, reduziert wird. Eine solche Wärmeisolierung wirkt jedoch auch dann, wenn die Kühlplatten zum gerichteten Erstarren der Schmelze an den Tiegel zurückgefahren werden und limitiert so die über die Kühlplatten abführbare Wärmemenge. Bei einer Steigerung der Kristallisationsgeschwindigkeit, die aus wirtschaftlichen Gründen gewünscht ist, ist für eine stabile Kristallisation ein möglichst hoher Temperaturgradient an der Phasengrenze zwischen fester und flüssiger Phase erforderlich. Dies erfordert eine möglichst hohe Wärmeabfuhr an der Unterseite des Tiegels, wobei jedoch auf die Einhaltung möglichst ebener Isothermen zu achten ist.

Mit dem Ziel, eine möglichst hohe Wärmeisolation während des Aufschmelzens der Schmelze in dem Schmelztiegel im abgesenkten Zustand der Kühlplatten zu ermöglichen, offenbart die gattungsbildende DE 297 15 846 U 1 eine Vorrichtung mit einer Mehrzahl von plattenförmigen Körpern, die parallel und beabstandet zueinander und parallel zur Bodenplatte des Schmelztiegels angeordnet sind und als Strahlungsschilde wirken, um die auftretende Wärmestrahlung zu reduzieren. Die Strahlungsschilde selbst bestehen aus einer Graphitfolie oder aus sehr dünnen Metallblechen, mit einer Dicke von nur 0,01 mm bis 0,2 mm und sind somit nicht formstabil. Die Strahlungsschilde sind über jeweils elastisch verformbare Abstandshalter, die als Federn ausgebildet sind, miteinander verbunden. Der Abstand zwischen der so ausgebildeten Wärmeisolationsanordnung und der Bodenplatte des Schmelztiegels kann durch eine Hubstange verändert werden. Das Wärmeisolationsvermögen der Wärmeisolationsanordnung ist dabei stets durch eine Kombination aus Wärmestrahlung und Wärmeleitung über ein in die Hohlräume zwischen den plattenförmigen Körpern eingebrachtes Gas definiert. Somit ist die durch diese Wärmeisolationsanordnung abführbare Wärmemenge limitiert. Auch ist der Unterschied des Wärmeisolationsvermögens in den beiden Extremstellungen der Wärmeisolationsanordnung, wie durch die Hubstange festgelegt, begrenzt.

DE 10 2005 014 051 A1 offenbart eine Wärmeisolationsanordnung gemäß dem Oberbegriff von Patentanspruch 1. Diese umfasst eine Mehrzahl von plattenförmigen Körpern, die entlang einer vorgegebenen Richtung aufeinander folgend angeordnet sind, und eine zugeordnete Verstelleinrichtung zum Verstellen von zumindest einem der plattenförmigen Körper in der vorgegebenen Richtung, wobei zumindest eine Teilgruppe der plattenförmigen Körper in einer ersten Stellung in der vorgegebenen Richtung zueinander beabstandet angeordnet sind, und mittels der Verstelleinrichtung der Abstand zumindest zwischen den plattenförmigen Körpern der vorgenannten Teilgruppe so veränderbar ist, dass diese vollflächig aneinander anliegen, um das Wärmeisolationsvermögen der Wärmeisolationsanordnung zu verändern. Zwischen den plattenförmigen Körpern ist jedoch keinerlei Wärmedämmeinlage vorgesehen. Die plattenförmigen Körper werden von gestuft ausgebildeten Führungsstangen geführt und sind entlang von diesen verstellbar gelagert.

## Zusammenfassung der Erfindung

Aufgabe der vorliegenden Erfindung ist es, die gattungsbildende Wärmeisolationsanordnung dahingehend weiterzubilden, dass damit die Effizienz der Aufschmelzung und der Abkühlung eines Materials in einfacher Weise noch weiter verbessert werden soll. Weitere Gesichtspunkte der vorliegenden Erfindung betreffen ferner bevorzugte Verwendungen einer solchen erfindungsgemäßen Wärmeisolationsanordnung sowie die Bereitstellung einer entsprechenden Vorrichtung und eines entsprechenden Verfahrens zur Herstellung von ein- oder multikristallinen Materialien oder für andere Anwendungen, beispielsweise zur kontrollierten Abkühlung von Glasformkörpern.

Diese Aufgaben werden gelöst durch eine Wärmeisolationsanordnung nach Anspruch 1, durch eine Vorrichtung zur Herstellung von ein- oder multikristallinen Materialien nach einem VGF-Verfahren nach Anspruch 13, ein entsprechendes Verfahren nach Anspruch 15 sowie entsprechende Verwendungen. Weitere vorteilhafte Ausführungsformen sind Gegenstand der rückbezogenen Unteransprüche.

Somit geht die vorliegende Erfindung aus von einer Wärmeisolationsanordnung mit einem variablen Wärmeisolationsvermögen, beispielsweise für Schmelztiegel, umfassend eine Mehrzahl von plattenförmigen Körpern, die entlang einer vorgegebenen Richtung aufeinander folgend angeordnet sind, und eine zugeordnete Verstelleinrichtung zum Verstellen von zumindest einem der plattenförmigen Körper in der vorgegebenen Richtung, wobei zumindest eine Teilgruppe der plattenförmigen Körper in einer ersten Stellung in der vorgegebenen Richtung zueinander beabstandet angeordnet sind, um so als wärmeisolierende Strahlungsschilde zu wirken, und wobei mittels der Verstelleinrichtung der Abstand zumindest zwischen den plattenförmigen Körpern der vorgenannten Teilgruppe so verändert werden kann, dass diese vollflächig aneinander anliegen.

In der ersten Stellung wird die Abführung von Wärme beherrscht durch Wärmestrahlung, die jedoch von einem benachbarten Strahlungsschild teilweise zurück reflektiert wird, was so zu einem hohen Wärmeisolationsvermögen führt. Durch den vollflächigen Kontakt zwischen benachbarten plattenförmigen Körpern kann in der zweiten Stellung effizient Wärme abtransportiert werden. Auf diese Weise kann das Wärmeisolationsvermögen der Wärmeisolationsanordnung durch einfaches mechanisches Verstellen der Strahlungsschilde verändert werden. Anders als in der DE 297 15 846 U1 dargestellt ist, dafür erfindungsgemäß kein gasdichter Behälter nötig.

Erfindungsgemäß ist in einer eine Ebene aufspannenden Oberfläche eines jeweiligen plattenförmigen Körpers, insbesondere in dessen Oberseite und/oder Unterseite, zumindest eine Ausnehmung ausgebildet ist, um einen im Querschnitt bevorzugt korrespondierend ausgebildeten Wärmedämmkörper aufzunehmen, der in einem Normalzustand jeweils über die Oberfläche hinausragt und durch Kraftbeaufschlagung senkrecht zur Oberfläche elastisch komprimierbar oder rückstellbar ist, bis dieser jeweils bündig mit der Oberfläche abschließt. Im letztgenannten Zustand können die plattenförmigen Körper somit vollflächig aneinander anliegen, während ansonsten ein gewisser Abstand zwischen den plattenförmigen Körpern vorherrscht. Die elastische Rückstellkraft erlaubt eine automatisch, selbsttätige Rückstellung der Wärmeisolationsanordnung in ihren maximal Wärme isolierenden Zustand, wenn die Verstellkraft zum Verstellen der plattenförmigen Körper nicht mehr anliegt.

Eine mechanische Verstellung der plattenförmigen Körper lässt sich in vorteilhaft einfacher Weise dann realisieren, wenn die plattenförmigen Körper vertikal übereinander angeordnet sind und die Verstelleinrichtung den Abstand zwischen diesen durch Anheben und Absenken des untersten plattenförmigen Körpers verändert. Durch das Anheben liegen schließlich die plattenförmigen Körper auf einem jeweils darunter befindlichen plattenförmigen Körper auf, bis schließlich alle plattenförmigen Körper unmittelbar und vollflächig aufeinander aufliegen.

Gemäß einer weiteren Ausführungsform ist zusätzlich zumindest ein Führungsmittel zum Führen der plattenförmigen Körper in der vorgegebenen Richtung vorgesehen. Bevorzugt ist dieses Führungsmittel jeweils als Führungsstange ausgebildet.

Zum Zweck der Erzielung der vorgenannten elastischen Rückstellkraft ist der jeweilige Wärmedämmkörper bevorzugt als ein elastisch verformbarer Filz aus einem hochtemperaturfesten Material ausgebildet, beispielsweise als ein elastisch verformbarer Filz aus Graphit, $Al_2O_3$, $SiO_2$, MgO oder $Zr_2O_3$ oder Mischungen.

Gemäß einer weiteren Ausführungsform ist die jeweilige Ausnehmung umlaufend und korrespondierend zur Querschnittsform des plattenförmigen Körpers ausgebildet, was zu einer gleichmäßigen Verstellung der plattenförmigen Körper führt und die Neigung derselben zu einer Verwölbung bei externer Krafteinwirkung gering hält.

Dabei sind die Ausnehmungen bevorzugt konzentrisch und kreisförmig ausgebildet, insbesondere für den Fall eines zylindrischen oder viereckigen Schmelztiegels.

Gemäß einer weiteren Ausführungsform ist auf einem Boden der jeweiligen Ausnehmung zumindest ein Vorsprung ausgebildet, der an dem zugeordneten Wärmedämmkörper anliegt oder in diesen geringfügig eingedrückt ist, wobei der Wärmedämmkörper in einem Normalzustand, d.h. in einem entspannten oder nur gering komprimierten Zustand, über die Oberfläche des plattenförmigen Körpers hinausragt. Auf diese Weise kann ein Spalt zwischen dem in der Ausnehmung aufgenommenen Wärmedämmkörper und dem plattenförmigen Körper festgelegt sein, der das Wärmeisolationsvermögen einer Anordnung, die mehrere übereinander gestapelt angeordnete plattenförmige Körper umfasst, in gewissem Maße beeinflussen kann.

Bevorzugt ist der jeweilige Wärmedämmkörper dabei so ausgelegt, dass in dem vorgenannten Normalzustand zwischen einem die jeweilige Ausnehmung seitlich begrenzenden Rand bzw. Vorsprung und dem benachbarten plattenförmigen Körper in der vorgegebenen Richtung ein Spalt ausgebildet ist, der das Wärmeisolationsvermögen einer Anordnung, die mehrere übereinander gestapelt angeordnete plattenförmige Körper umfasst, weiter beeinflusst.

Der Vorsprung ist dabei durch geeignete Wahl seiner Höhe und/oder Fläche so auf die elastischen Eigenschaften des zugeordneten Wärmedämmkörpers und die Dimensionen der diesen aufnehmenden Ausnehmung abgestimmt, dass in dem vollständig komprimierten Zustand der Vorsprung vollständig in den Wärmedämmkörper eingedruckt ist, der Wärmedämmkörper die zugeordnete Ausnehmung im Wesentlichen vollständig ausfüllt, also am Boden der Ausnehmung sowie an der vorgenannten Oberfläche eines benachbarten plattenförmigen Körpers anliegt, und der die zugeordnete Ausnehmung seitlich begrenzende Vorsprung bzw. Rand an der Oberfläche eines benachbarten plattenförmigen Körpers anliegt. Auf diese Weise wird in dem vollständig komprimierten Zustand ein vollflächiger Kontakt zwischen benachbarten plattenförmigen Körpern bewerkstelligt, der in einem sehr viel höheren Wärmeleitvermögen resultiert als in dem entspannten Normalzustand, in welchem zwischen den plattenförmigen Körpers jeweils ein Spalt ausgebildet ist.

Durch die gestapelte Anordnung der plattenförmigen Körper unmittelbar übereinander kann ferner auf aufwändige Führungs- und Verstellmechanismen verzichtet werden.

Ergänzend oder als Alternative zu den vorgenannten elastisch verformbaren Wärmedämmeinlagen ist gemäß einer weiteren Ausführungsform in der jeweiligen Ausnehmung ein elastisches Rückstellmittel vorgesehen, um den zugeordneten Wärmedämmkörper elastisch zurückzustellen, sodass dieser durch Kraftbeaufschlagung senkrecht zur Oberfläche elastisch rückstellbar ist, bis dieser bündig mit der Oberfläche abschließt. Das elastische Rückstellmittel kann dabei Graphitfolien und/oder Metallfolien bzw. -bleche umfassen oder von diesen ausgebildet sein.

Gemäß einer weiteren Ausführungsform ist der jeweilige Wärmedämmkörper aus einem inelastischen Material ausgebildet und so ausgelegt, dass dieser in einem unkomprimierten Zustand bzw. Normalzustand der Wärmeisolationsanordnung nicht über die vorgenannte Oberfläche hinausragt, also vollständig in der jeweils zugeordneten Ausnehmung angeordnet ist. Der Abstand der einzelnen Platten sollte dann durch andere Mittel veränderbar sein.

Eine Wärmeisolationsanordnung wie vorstehend beschrieben wird bevorzugt in einer Vorrichtung zum gerichteten Erstarren von Schmelzen in einem Tiegel verwendet, wobei die Wänneisolationsanordnung unterhalb des Tiegels angeordnet ist und eine Wärmeabfuhr von dem Boden des Tiegels durch Ändern des Wärmeisolationsvermögens der Wärmeisolationsanordnung angepasst wird.

Ein weiterer Gesichtspunkt der vorliegenden Erfindung betrifft eine Vorrichtung zur Herstellung von ein- oder multikristallinen Materialien nach dem Vertical-Gradient-Freeze-Verfahren (VGF-Verfahren), insbesondere von multikristallinem Silizium, mit einem feststehenden Tiegel und einer Heizeinrichtung. Die Vorrichtung zeichnet sich durch eine Wärmeisolationsanordnung aus, die wie vorstehend beschrieben ausgebildet und ausgelegt ist und auf welcher der Tiegel abgestützt ist oder unterhalb des Bodens des Tiegels angeordnet ist, wobei durch Ändern des Wärmeisolationsvermögens der Wärmeisolationsanordnung ein vertikaler Temperaturgradient in dem Tiegel veränderbar ist.

Ein weiterer Gesichtspunkt der vorliegenden Erfindung betrifft ferner ein Verfahren zur Herstellung von ein- oder multikristallinen Materialien nach dem Vertical-Gradient-Freeze-Verfahren (VGF-Verfahren), insbesondere von multikristallinem Silizium, in einem feststehenden Tiegel, wobei eine Heizeinrichtung das in den Tiegel eingebrachte Material schmilzt und die Schmelze durch Wärmeabfuhr in Richtung auf eine den Tiegel abstützende Bodenplatte gerichtet erstarrt, wobei durch Ändern des Wärmeisolationsvermögens der Wärmeisolationsanordnung, die wie vorstehend beschrieben ausgebildet und ausgelegt ist, ein vertikaler Temperaturgradient in dem Tiegel eingestellt wird.

Ein weiterer Gesichtspunkt der vorliegenden Erfindung betrifft ferner ein Verfahren zur Herstellung von Glaskörpern bzw. die Verwendung der vorgenannten Wärmeisolationsanordnung bei der Herstellung von Glaskörpern, wobei die Wärmeisolationsanordnung als Isolationsmaterial in einem Ofen verwendet wird, durch den der Glaskörper beispielsweise nach dessen Formgebung hindurchläuft, um darin kontrolliert abzukühlen.

**Figurenübersicht**

Nachfolgend wird die Erfindung in beispielhafter Weise und unter Bezugnahme auf die beigefügten Zeichnungen beschrieben werden, woraus sich weitere Vorteile, Merkmale und zu lösende Aufgaben ergeben werden. Es zeigen:

| | |
|---|---|
| Fig. 1a | in einem Querschnitt einen Strahlungsschild einer Wärmeisolationsanordnung gemäß einer ersten Ausführungsform der vorliegenden Erfindung; |
| Fig. 1b | in einem Querschnitt einen Strahlungsschild einer Wärmeisolationsanordnung gemäß einer zweiten Ausführungsform der vorliegenden Erfindung; |
| Fig. 2a und 2b | in einer Gegenüberstellung und jeweils im Querschnitt eine aus den Strahlungsschilden gemäß der Fig. 1a gebildete Wärmeisolationsanordnung in einem entspannten Zustand und in einem vollständig komprimierten Zustand; |
| Fig. 3a | in einem Querschnitt einen Strahlungsschild einer Wärmeisolationsanordnung gemäß einer dritten Ausführungsform der vorliegenden Erfindung in einem entspannten Zustand; |
| Fig. 3b | eine Draufsicht auf den Strahlungsschild gemäß der Fig. 3a; |
| Fig. 3c | in einem Querschnitt den Strahlungsschild gemäß der Fig. 3a in einem komprimierten Zustand; |
| Fig. 4a und 4b | in einer Gegenüberstellung und jeweils im Querschnitt eine aus mehreren Strahlungsschilden gemäß der Fig. 3a gebildete Wärmeisolationsanordnung in einem entspannten Zustand und einem vollständig komprimierten Zustand; |
| Fig. 5a | in einem schematischen Teilschnitt eine Wärmeisolationsanordnung, die einem besseren Verständnis der vorliegenden Erfindung dienen soll; |
| Fig. 5b | eine weitere Variante der Wärmeisolationsanordnung gemäß der Fig. 5b; |
| Fig. 5c | in einem schematischen Teilschnitt eine Wärmeisolationsanordnung gemäß einer vierten Ausführungsform; |
| Fig. 5d | eine weitere Variante der Wärmeisolationsanordnung gemäß der vierten Ausführungsform; |
| Fig. 6 | in einer schematischen Querschnittsdarstellung eine Vorrichtung zur Herstellung von multikristallinem Silizium gemäß der vorliegenden Erfindung, welche eine erfindungsgemäße Wärmeisolationsanordnung verwendet; |
| Fig. 7 bis 10 | das Ergebnis von Berechnungen des Temperatur- und Wärmetransportverhaltens von verschiedenen Wärmeisolationsanordnungen, wie nachfolgend erläutert; und |
| Fig. 11 | die Verwendung der erfindungsgemäßen Wärmeisolationsanordnung in einer Anlage zur Herstellung von Glaskörpern. |

In den Figuren bezeichnen identische Bezugszeichen identische oder im Wesentlichen gleich wirkende Elemente oder Elementgruppen.

**Ausführliche Beschreibung von bevorzugten Ausführungsbeispielen**

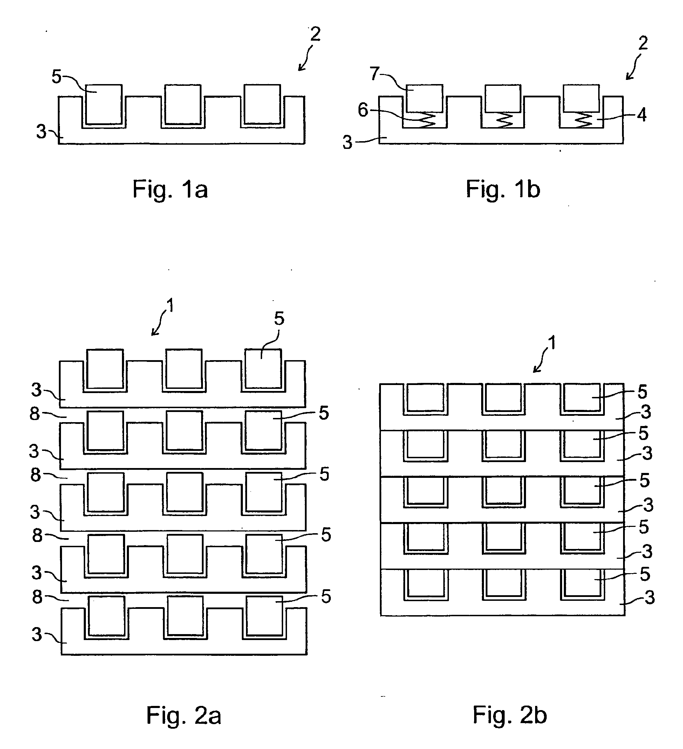

Gemäß der Fig. 1a sind in einem plattenförmigen Körper 3 mehrere Ausnehmungen ausgebildet, in dem dargestellten Ausführungsbeispiel jeweils mit rechteckförmigem Querschnitt, worin korrespondierend ausgebildete elastische Wärmedämmeinlagen 5 angeordnet sind. Bevorzugt sind die elastischen Wärmedämmeinlagen 5 eng anliegend in den Ausnehmungen angeordnet, und zwar bevorzugt im Wesentlichen ohne seitliches Spiel. Die Querschnittsform des plattenförmigen Körpers 3 in Draufsicht kann an die Querschnittsform eines nicht dargestellten Schmelztiegels (z.B. rechteckförmig, kreisförmig) angepasst sein. Die Wärmedämmeinlagen 5 verfügen bei den bestimmungsgemäß hohen Temperaturen über eine ausreichende Elastizität, um elastisch komprimiert werden zu können. Insgesamt wird so ein Strahlungsschild 2 ausgebildet. Wenngleich in der Fig. 1a ein schmaler Spalt zwischen dem Boden der Ausnehmung und der Wärmedämmeinlage 5 aus Gründen der Vereinfachung der zeichnerischen Darstellung abgebildet ist, wird dem Fachmann ohne weiteres ersichtlich sein, dass die Wärmedämmeinlage 5 bevorzugt unmittelbar auf dem Boden der Ausnehmung aufliegt.

Gemäß der Fig. 2a sind eine Mehrzahl solcher Strahlungsschilde im Normalzustand bzw. im entspannten, d.h. nicht komprimierten, Zustand der elastischen Wärmedämmeinlagen 5 gestapelt übereinander angeordnet, wobei jeweils ein Spalt 8 zwischen den einzelnen Strahlungsschilden ausgebildet ist. Im Normalzustand bzw. entspannten Zustand können die Wärmedämmeinlagen 5 an den Unterseiten der darüber befindlichen plattenförmigen Körper 3 unmittelbar anliegen oder auch beabstandet zu diesen sein, wie in der Fig. 2a dargestellt, je nachdem ob in dem entspannten Zustand Wärme durch die Wärmeisolationsanordnung rein durch Wärmestrahlung und Konvektion durch ein in dem jeweiligen Spalt 8 befindliches Gas oder zusätzlich auch durch Wärmeleitung über die von den elastischen Wärmedämmeinlagen 5 und den plattenförmigen Körpern 3 ausgebildeten Wärmebrücken erfolgen soll. Wenngleich in der Fig. 2a ein schmaler Spalt zwischen dem Boden der Ausnehmung und der Wärmedämmeinlage 5 aus Gründen der Vereinfachung der zeichnerischen Darstellung abgebildet ist, wird dem Fachmann ohne weiteres ersichtlich sein, dass die Wärmedämmeinlagen 5 bevorzugt unmittelbar auf dem Boden der Ausnehmung aufliegen.

Bei einer so ausgebildeten Wärmeisolationsanordnung 1 sind eine Mehrzahl von Platten bzw. Scheiben mit Zwischenraum quer zur Wärmeflussrichtung angeordnet, sodass sich der Wärmetransport durch Strahlung durch Variieren des Abstands zwischen den einzelnen Platten bzw. Scheiben 3 beeinflussen lässt. Im Betrieb nehmen die plattenförmigen Körper 3 durchaus hohe Temperaturen an, sodass es notwendig ist, diese und auch deren Halterung aus hochtemperaturfesten Materialien zu fertigen. Bevorzugt sind die plattenförmigen Körper 3 aus Graphit gefertigt.

Die Fig. 2b zeigt die Wärmeisolationsanordnung gemäß der Fig. 2a in einem vollständig komprimierten Zustand, in welchem die elastischen Wärmedämmeinlagen 5 derart komprimiert sind, dass diese einerseits am Boden der in den plattenförmigen Körpern 3 ausgebildeten Ausnehmungen und andererseits an der Rückseite der jeweils angrenzenden plattenförmigen Körper 3 anliegen. Dieser Zustand kann durch Zusammendrücken der Strahlungsschilde bewerkstelligt werden, beispielsweise durch vertikales Verstellen des untersten plattenförmigen Körpers 3 bei festgehaltenem obersten plattenförmigen Körper 3. In dem dargestellten Zustand wird ein erheblicher Teil der Wärme aufgrund der Berührung zwischen den Strahlungsschilden durch Wärmeleitung durch die Wärmeisolationsanordnung 1 transportiert. Wenngleich in der Fig. 2b ein schmaler Spalt zwischen dem Boden der Ausnehmung und der Wärmedämmeinlage 5 aus Gründen der Vereinfachung der zeichnerischen Darstellung abgebildet ist, wird dem Fachmann ohne weiteres ersichtlich sein, dass die Wärmedämmeinlagen 5 bevorzugt unmittelbar auf dem Boden der Ausnehmung aufliegen.

Wie man der Zusammenschau gemäß den Fig. 2a und 2b ohne weiteres entnehmen kann, kann durch Variieren des Abstands zwischen den einzelnen Strahlungsschilden die durch die Wärmeisolationsanordnung 1 abtransportierbare Wärmemenge geeignet kontrolliert werden. Hierzu ist lediglich eine mechanische Verstellung der Lage der Strahlungsschilde relativ zueinander erforderlich, beispielsweise durch vertikales Verstellen des untersten plattenförmigen Körpers 3, wie nachfolgend ausgeführt.

Wenngleich in den Figuren 2a und 2b dargestellt ist, dass die elastischen Wärmedämmeinlagen 5 fluchtend angeordnet sind, können diese auch versetzt angeordnet sein, beispielsweise im Querschnitt alternierend in einem Zick-Zack-Muster oder entlang einer schräg verlaufenden Linie. Die einzelnen Strahlungsschilde können dabei gemeinsam gleichmäßig aufeinander zu bewegt werden oder aber mit unterschiedlichen Verstellraten oder gar selektiv und unabhängig voneinander. So kann beispielsweise jedem einzelnen Strahlungsschild eine gesonderte nicht dargestellte Verstelleinrichtung zugeordnet sein, sodass jeder Strahlungsschild selektiv, je nach den einzuhaltenden Randbedingungen, vertikal verstellt werden kann. Es können auch Maßnahmen getroffen werden, die bewirken, dass trotz einer Verstellung mit Hilfe nur einer einzelnen Verstelleinrichtung, die beispielsweise an dem untersten plattenförmigen Körper angreift, um diesen vertikal aufwärts und abwärts zu verstellen, dennoch eine unterschiedliche Verstellung der einzelnen Strahlungsschilde relativ zueinander erzielt wird. Dies kann durch einen unterschiedlichen Elastizitätsmodul der Wärmedämmeinlagen 5 von unterschiedlichen Strahlungsschilden bewerkstelligt werden, wobei die Wärmedämmeinlagen 5 desselben Strahlungsschilds bevorzugt denselben Elastizitätsmodul aufweisen. Alternativ kann der Elastizitätsmodul der einzelnen Wärmedämmeinlagen 5 zwar identisch sein, können jedoch entweder die Tiefen der Ausnehmungen von unterschiedlichen Strahlungsschilden und/oder die Querschnittsflächen (in Draufsicht betrachtet) der Ausnehmungen und der darin aufgenommenen Wärmedämmeinlagen 5 unterschiedlich gewählt werden. Über das bekannte Federgesetz bzw. die Abhängigkeit des Drucks von der Verstellkraft und der Querschnittsfläche lässt sich so bei Anlegen einer einheitlichen Verstellkraft eine unterschiedliche Verstellung der einzelnen Strahlungsschilde relativ zueinander erzielen.

Die Fig. 1b zeigt in einer Querschnittsansicht einen Strahlungsschild 2 gemäß einer zweiten Ausführungsform der vorliegenden Erfindung. In dem plattenförmigen Körper 3 sind mehrere Ausnehmungen 4 vorgesehen, beispielsweise eine zentrale, zylindertopfförmige Ausnehmung und eine ringförmige Ausnehmung 4, und zwar jeweils mit einem rechteckförmigen Querschnitt. In den Ausnehmungen 4 sind korrespondierend ausgebildete Wärmedämmeinlagen 7 aufgenommen, bevorzugt eng anliegend. Eine elastische Rückstellkraft zum Vorspannen der Wärmedämmeinlagen 7 relativ zu dem plattenförmigen Körper 3 wird durch Einbringen von Federelementen 6, die bei den bestimmungsgemäßen hohen Temperaturen über eine ausreichende Elastizität verfügen, erzielt, wie schematisch durch das allgemein ein Federelement bezeichnende Bezugszeichen 6 angedeutet. Die Federkraft sämtlicher Federelemente 6 desselben Strahlungsschilds 2 ist bevorzugt identisch. Bei den Federelementen 6 kann es sich beispielsweise um Blattfedern aus speziellen Graphitfolien, Metallblechen oder Laminatplatten handeln. Grundsätzlich kann auch vorgesehen sein, ein solches Federelement als Einlage aus einem Graphitfilz auszubilden.

Wie der Zusammenschau der Fig. 1a und 1b entnommen werden kann, sind die Wärmedämmeinlagen 5 bzw. 7 aufgrund ihrer auf die Ausnehmungen 4 abgestimmten Formgestaltung in den Ausnehmungen 4 bevorzugt geradgeführt.

Mehrere Strahlungsschilde 2 gemäß der zweiten Ausführungsform können in der vorstehend anhand der Fig. 2a und 2b beschriebenen Weise gestapelt übereinander angeordnet werden, um eine entsprechend wirkende Wärmeisolationsanordnung auszubilden. Bei beiden Ausführungsformen ist zwischen den einzelnen Strahlungsschilden in einem entspannten Zustand bzw. Normalzustand ein Spalt ausgebildet, dessen Breite entweder unmittelbar durch die aus den Strahlungsschilden herausragenden Wärmedämmeinlagen oder durch eine externe Führungs- und/oder Verstelleinrichtung vorgegeben ist, während in einem komprimierten Zustand diese Spaltbreite reduziert oder verschwindend ist. Während in dem Normalzustand das Wärmeisolationsvermögen der Wärmeisolationsanordnung sehr hoch ist, ist das Wärmeisolationsvermögen der Wärmeisolationsanordnung in dem komprimierten Zustand deutlich geringer. Zwischen beiden Zuständen kann durch einfache mechanische Belastung der Wärmeisolationsanordnung umgeschaltet werden. Durch geeignete Steuerung der mechanischen Belastung kann das Wärmeisolationsvermögen in einfacher Weise sehr präzise reguliert bzw. eingestellt werden.

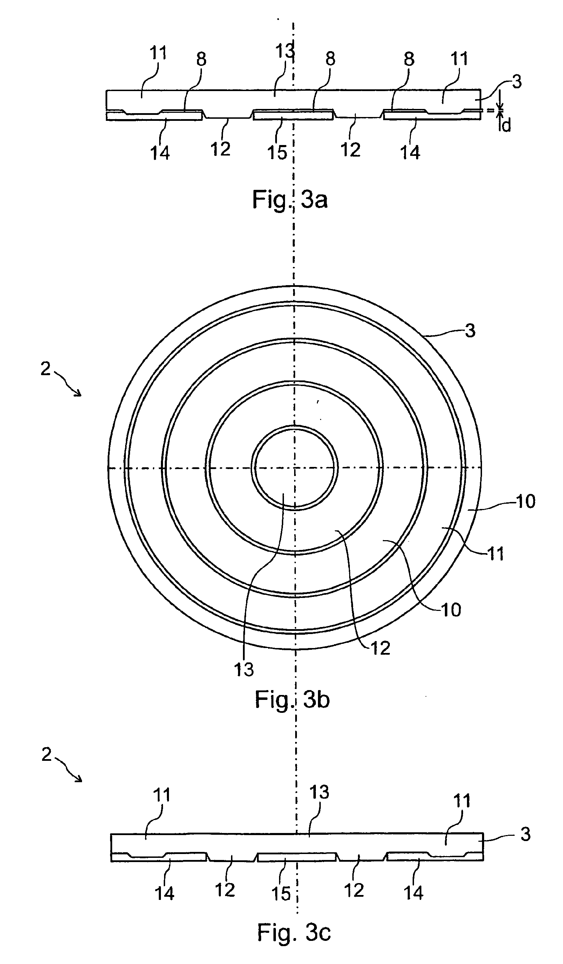

Das Material der Wärmedämmeinlage 7 gemäß der zweiten Ausführungsform (vgl. Fig. 1b) ist bevorzugt inelastisch und nicht komprimierbar und kann insbesondere als Graphit- oder Metalleinlage ausgebildet sein. Bei der ersten Ausführungsform muss jedoch die Wärmedämmeinlage 5 bei den bestimmungsgemäß hohen Temperaturen in ausreichendem Masse elastisch komprimierbar sein, zu welchem Zweck für die Wärmedämmeinlagen 5 (vgl. Fig. 1a) Graphitfilze oder Filze aus anderen elastisch verformbaren und hochtemperaturfesten Materialien, beispielsweise aus $Al_2O_3$, $SiO_2$, $MgO$ oder $Zr_2O_3$ oder Mischungen daraus, oder aus Metallen. Das Wärmeleitvermögen eines Strahlungsschilds 2 ist dabei im Wesentlichen durch den anteilig gemittelten Wärmeleitwert von plattenförmigern Körper 3 und Einlage 5 bzw. 7, durch die Dicke eines Strahlungsschilds 2 und die Flächenverhältnisse von Wärmedämmeinlage 5 bzw. 7 und plattenförmigem Körper 3 vorgegeben und kann geeignet variiert werden. Der spezifische Wärmeleitwert eines Strahlungsschilds 2 und der Wärmedämmeinlagen 5 bzw. 7 kann dabei im Wesentlichen identisch oder unterschiedlich sein. Insbesondere kann der spezifische Wärmeleitwert der Wärmedämmeinlagen 5 bzw. 7 auch kleiner sein als der des zugeordneten Strahlungsschilds 2. Anhand der Fig. 3a bis 3c wird nachfolgend ein Strahlungsschild gemäß einer dritten Ausführungsform der vorliegenden Erfindung beschrieben, der auf dem Prinzip gemäß dem ersten Ausführungsbeispiel 1 beruht. Gemäß den Fig. 3a und 3b ist der Strahlungsschild 2 in Draufsicht kreisförmig und umfasst einen plattenförmigen Körper 3, in welchem eine zentrale, zylindertopfförmige Ausnehmung 13 sowie eine umlaufende, ringförmige Ausnehmung 10 ausgebildet ist, die sich bis zum Umfangsrand des plattenförmigen Körpers 3 erstreckt. Selbstverständlich können auch mehrere solcher ringförmigen Ausnehmungen konzentrisch angeordnet sein. Von dem Boden der ringförmigen Ausnehmung 10 ragt ein umlaufender Vorsprung 11 ab, der eine vorbestimmte Höhe d1 aufweist. In der zentralen Ausnehmung 13 und der äußeren Ausnehmung 10 sind elastische Dämmeinlagen 15 bzw. 14 aufgenommen, die korrespondierend zu den Ausnehmungen 13 bzw. 10 ausgebildet sind. Der Vorsprung 11 bildet im unkomprimierten Zustand eine Auflagefläche und liegt entweder auf der zugeordneten Wärmedämmeinlage 14 unmittelbar auf oder wird aufgrund des Eigengewichtes der Platte 2 in die elastische Wärmedämmeinlage 14 gedrückt, sodass zwischen dem Boden der Ausnehmung 10 und der Wärmedämmeinlage 14 ein Spalt 8 mit einer lichten Weite d ausgebildet ist. Der Vorsprung 12 ist dabei so dimensioniert, dass die die Ausnehmungen 10, 13 seitlich begrenzenden Ränder bzw. Vorsprünge 12 keinen Kontakt zur Unterlage ausbilden, sondern in einem Abstand d2 zu dieser gehalten werden. Über die Fläche des Vorsprungs 11 wird die Rückstellkraft des Aufbaus definiert. Die Dicke der Dämmeinlagen 14, 15 entspricht im komprimierten Zustand der Tiefe der Ausnehmungen 13, 10. In dem in der Fig. 3a dargestellten entspannten, d.h. nicht komprimierten Zustand der Wärmedämmeinlagen 14, 15 ist zwischen dem Vorsprung 12 und der Unterlage (beispielsweise der Oberseite eines darunter befindlichen Strahlungsschilds) ein Spalt mit einer lichten Weite d2 ausgebildet.

Die Fig. 3c zeigt den Strahlungsschild 2 gemäß der Fig. 2a in einem vollständig komprimierten Zustand, in welchem der Vorsprung 11 in die Dämmeinlage 14 zusätzlich zur Distanz d1 um die Distanz d2 hineingedrückt ist und die Vorsprünge 12 in direktem Kontakt zur nicht dargestellten Unterlage (beispielsweise der Oberseite eines darunter befindlichen Strahlungsschilds) stehen.

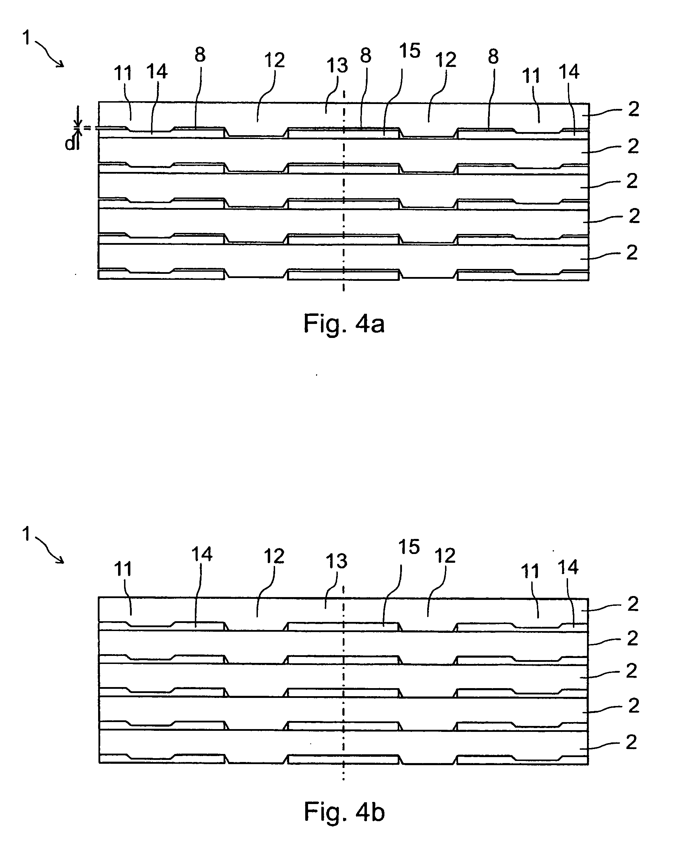

Gemäß der Fig. 4a sind eine Mehrzahl solcher Strahlungsschilde 2 gestapelt übereinander angeordnet, um eine Wärmeisolationsanordnung gemäß der dritten Ausführungsform der vorliegenden Erfindung auszubilden. Dabei werden die ringförmigen Vorsprünge 12, welche die Ausnehmungen 10, 13 voneinander trennen bzw. seitlich begrenzen, von den elastischen Wärmedämmeinlagen 14, 15 in einem Abstand d2 zu der Oberseite eines darunter befindlichen Strahlungsschilds 2 gehalten, wenn die Dämmeinlagen 14, 15 noch nicht komprimiert sind. Dies entspricht im Wesentlichen dem in der Fig. 2a dargestellten Zustand, in welchem ein Spalt 8' zwischen den Rändern bzw. Vorsprüngen 12 und dem darunter befindlichen Strahlungsschild 12 ausgebildet ist.

Durch Komprimieren der Anordnung gemäß der Fig. 4a wird schließlich der vollständig komprimierte Zustand gemäß der Fig. 4b erreicht, in welchem die Dämmeinlagen 15, 14 vollständig komprimiert sind und somit die Vorsprünge 12 unmittelbar an der Oberseite eines darunter befindlichen Strahlungsschilds anliegen. In diesem Zustand wird ein erheblicher Teil der Wärme auch durch Wärmeleitung durch die Wärmeisolationsanordnung 1 abtransportiert.

Auch bei der dritten Ausführungsform können den einzelnen Strahlungsschilden 2 jeweils eigene Verstelleinrichtungen zugeordnet sein oder kann durch geeignete Variation der Tiefe der Ausnehmungen und/oder der Flächen der Dämmeinlagen und/oder der Höhe und/oder Fläche der Vorsprünge 12 und 11 eine unterschiedliche Verstellung der Strahlungsschilde 2 relativ zueinander bei Einwirken einer einheitlichen Verstellkraft erzielt werden. Die beiden Erfindungsaspekte können dabei erfindungsgemäß auch miteinander kombiniert werden.

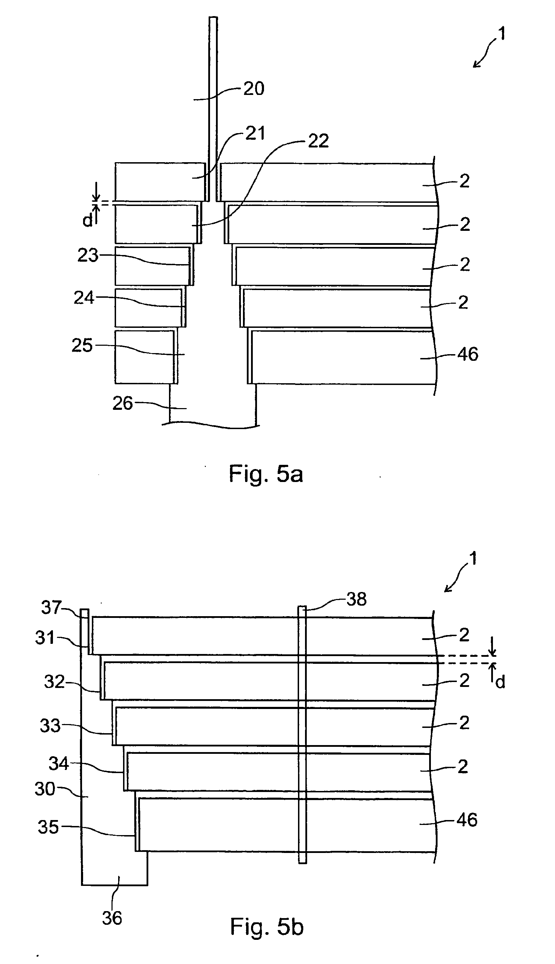

Wie dem Fachmann beim Studium der vorstehenden Ausführungsformen ohne weiteres ersichtlich sein wird, kann bei diesen Ausführungsformen eine Führungseinrichtung vorgesehen sein, um ein seitliches Verrutschen der einzelnen Strahlungsschilde relativ zueinander zu verhindern. Eine solche Führungseinrichtung kann insbesondere auch so ausgebildet sein, wie nachfolgend anhand der Figuren 5a bis 5d beschrieben.

Die Figuren 5a und 5b zeigen weitere Wärmeisolationsanordnungen, bei denen kein elastischer Werkstoff verwendet wird und die einem besseren Verständnis der vorliegenden Erfindung dienen sollen. Eine solche Ausführungsform wird nachfolgend anhand der Fig. 5a und 5b beschrieben.

Die Fig. 5a zeigt den Randbereich einer aus mehreren vertikal übereinander angeordneten Strahlungsschilden 2 ausgebildeten Wärmeisolationsanordnung 1. In diesem Bereich ist eine sich vertikal erstreckende Führungsstange 26 angeordnet, auf der mehrere zylindrische Stufen 21 bis 25 mit unterschiedlichen Außendurchmessern vorgesehen sind. Am oberen Ende des Schafts 26 ist eine Führungsstange 20 vorgesehen. Die Anzahl der Stufen 21 - 25 entspricht der Anzahl von abzustützenden Platten 2, 46, wobei die Höhen der Stufen 21 - 25 größer sind als die Dicken der abzustützenden Platten 2, 46. Somit ruhen die Platten 2, 46 am Boden der zugeordneten Stufen 21 - 25, deren Außendurchmesser gemäß der Fig. 5a von unten nach oben kontinuierlich abnimmt. Entsprechend sind in den Platten 2, 46 Bohrungen ausgebildet, deren Durchmesser auf den Außendurchmesser der zugeordneten Stufe 21 - 25 abgestimmt ist.

Wenn die unterste Platte 46 aufwärts verstellt wird, die Stufen aber ortsfest bleiben, nimmt der Abstand zwischen der Platte 46 und dem darüber befindlichen untersten Strahlungsschild 2 ab, bis schließlich die Platte 46 an diesem unmittelbar anliegt. Beim weiteren Anheben der Platte 46 gelangt schließlich der unterste Strahlungsschild 2 in Anlage mit dem darüber befindlichen Strahlungsschild 2, solange bis sämtliche Platten 2, 46 unmittelbar aneinander anliegen und mittels der Führungsstange 20 weiter vertikal geführt werden, bis ein gewünschter Abstand, der auch verschwindend sein kann, zu dem oberhalb der Wärmeisolationsanordnung 1 befindlichen Schmelztiegel (nicht gezeigt) erreicht ist. Bei einer solchen Wärmeisolationsanordnung 1 sind mehrere solcher gestuften Führungsstangen 26 in geeigneter Anordnung vorgesehen, beispielsweise in Draufsicht in einer Dreieck- oder Viereck-Anordnung. Bei diesem Ausführungsbeispiel wird der Abstand zwischen den einzelnen Platten 2, 46 durch die Differenz der Dicke einer jeweiligen Platte 2, 46 und der Höhe der zugeordneten Stufe 21 - 25 vorgegeben und kann so in einfacher Weise voreingestellt werden.

Während in dem Zustand gemäß der Fig. 5a, in welchem sämtliche Platten 2, 46 beabstandet zueinander sind, das Wärmeleitvermögen der Wärmeisolationsanordnung 1 durch Strahlung und Konvektion eines im Spalt zwischen den Platten 2, 46 befindlichen Gases, beispielsweise Argon, bestimmt wird, wird das Wärmeisolationsvermögen in dem Zustand, in dem sämtliche Platten 2, 46 unmittelbar aneinander anliegen, im Wesentlichen durch die Wärmeleitfähigkeit der Platten 2, 46 bestimmt.

Die Fig. 5b zeigt eine Mödifikation, bei der statt mehrerer gestufter Führungsstangen 26, wie in der Fig. 5a dargestellt, ein einzelnes kreisförmiges oder vieleckiges Ringstück 30 vorgesehen ist, das als Führungsaufnahme wirkt und auf dessen Innenumfangsrand mehrere Stufen 31 bis 35 mit unterschiedlichen Innenweiten bzw. Innendurchmessern ausgebildet sind. Die Innenweite bzw. der Innendurchmesser der Stufen 31 - 35 nimmt von unten nach oben kontinuierlich zu. Die Höhen der Stufen 31 - 35 sind um eine vorbestimmte Distanz d größer als die Dicke der zugeordneten Platten 2, 46. Die Platten 2, 46 sind an einer oder mehreren Führungsstangen 38 in vertikaler Richtung gerade geführt. In dem Zustand gemäß der Fig. 5b liegen die Platten 2, 46 am Boden der Stufen 31 - 35 des Ringstücks 30 unmittelbar auf. In diesem Zustand sind sämtliche Platten 2, 46 beabstandet zueinander, entweder mit einem einheitlichen Abstand d oder unter unterschiedlichen Abständen. Durch weiteres Anheben der untersten Platte 46 in der vorstehend beschriebenen Weise können schließlich alle Platten 2, 46 in unmittelbare Anlage miteinander gebracht werden, wie vorstehend anhand der Fig. 5a beschrieben.

Während die Platten der Strahlungsschilde 2 nach den Figuren 5a und 5b bevorzugt aus Graphit gefertigt sind, handelt es sich bei der untersten Platte 46 bevorzugt um eine kühlbare Platte, beispielsweise um eine Metallplatte, die von einem kühlenden Fluid durchströmt oder umströmt wird.

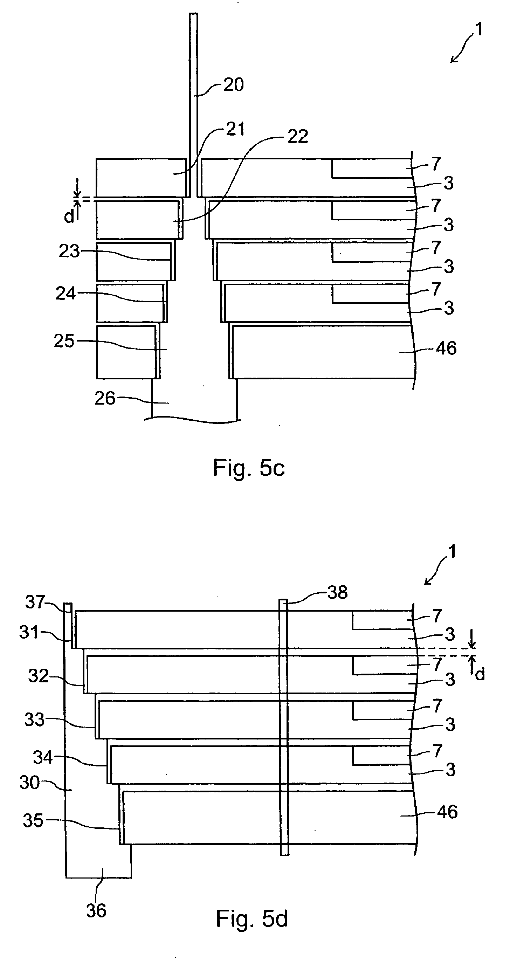

Die Fig. 5c zeigt eine Variante der Wärmeisolationsanordnung gemäß der Fig. 5a als vierte Ausführungsform der vorliegenden Erfindung, mit einer Mehrzahl von Strahlungsschilden 3, wie vorstehend beschrieben, und zumindest einer gestuften Führungsstange 20. Abweichend zur Fig. 5a sind in Ausnehmungen der Strahlungsschilde 3 inelastische Wärmedämmkörper 7 aufgenommen, die nicht über die Oberseite der Strahlungsschilde 3 hinausragen.

Die Fig. 5d zeigt eine Variante der Wärmeisolationsanordnung gemäß der Fig. 5c, mit einer Mehrzahl von Strahlungsschilden 3, wie vorstehend anhand der Fig. 5b beschrieben, zumindest einer Führungsstange 38 und einem Ringstück 30 mit einer Mehrzahl von Stufen 31 - 35. Abweichend zur Fig. 5b sind in Ausnehmungen der Strahlungsschilde 3 inelastische Wärmedämmkörper 7 aufgenommen, die nicht über die Oberseite der Strahlungsschilde 3 hinausragen.

Über die Abmessungen der Wärmedämmkörper, insbesondere ihre Fläche in Bezug auf die Gesamtfläche der Platten, lässt sich die Isolationswirkung der Wärmeisolationsanordnung in beiden Stellungen an den jeweiligen Prozess anpassen.

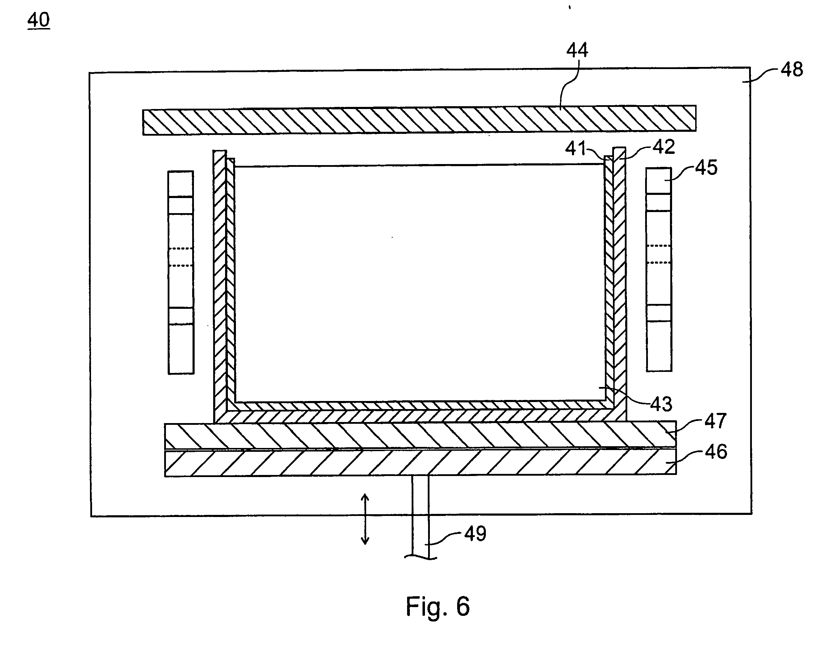

Die Fig. 6 zeigt ein Beispiel für ein Beispiel für eine bevorzugte Verwendung einer erfindungsgemäßen Wärmeisolationsanordnung in einer VGF-Kristallisationsanlage, die einen Tiegel mit einem viereckigen Querschnitt aufweist. Gemäß der Fig. 6 ist der Tiegel von einem Quarzglastiegel 41 ausgebildet, der zur Abstützung in einem korrespondierend ausgebildeten Graphitbehälter 42 eng anliegend aufgenommen ist. Das in dem Tiegel 41 aufgenommene Silizium 43 gelangt somit nicht in Anlage zu dem Graphitbehälter 42. Der Tiegel ist aufrecht stehend angeordnet, sodass die Tiegelwände entlang der Schwerkraft verlaufen. Oberhalb und unterhalb des Tiegels 41 befindet sich ein Deckelheizer 44 bzw. eine Kühlplatte 46, wobei zwischen dem Tiegel 41, 42 und der Kühlplatte 46 eine Bodenplatte 47 angeordnet ist, die erfindungsgemäß als Wärmeisolationsanordnung wie vorstehend beschrieben mit variablem Wärmeisolationsvermögen ausgebildet ist. Dabei ist die eigentliche Halterung des Tiegels 41, 42 so ausgebildet, dass zwischen der Kühlplatte 46 und der den Tiegel abstützenden Bodenplatte 47 bevorzugt ein schmaler Spalt ausgebildet ist. Umgeben wird die Kernzone des Tiegels von einem umlaufend angeordneten Mantelheizer 45. Die Heizer 44, 45 und die Kühlplatte 46 sind temperaturgeregelt.

Die gesamte Anordnung ist in einer Wärmeisolation 48 angeordnet, die kontrolliert unter einer Gasatmosphäre, beispielsweise Argon-Gasatmosphäre, gehalten werden kann. Beim VGF-Kristallisationsverfahren werden die Heizer 44, 45 und die Kühlplatte 46 so geregelt, dass während der Phase des Auskristallisierens des Siliziums zu jedem Zeitpunkt ebene, horizontale Phasengrenzen zwischen fester und flüssiger Phase vorherrschen. Während der Mantelheizer 45 Wärmeverluste in Umfangsrichtung kompensiert, wird der vertikale Temperaturgradient durch den Deckelheizer 44 und die Kühlplatte 46 sowie durch den Zustand der Wärmeisolationsanordnung 47 bestimmt.

Zu Beginn des Prozesses wird in den Schmelztiegel 41, 42 eine Silizium-Schmelze eingebracht bzw. diese durch Aufschmelzen eines Silizium-Rohmaterials und geeignete Temperaturführung der Heizer 44 - 45 hergestellt. Zum Auskristallisieren werden der Zustand der Wämieisolationsanordnung 47, die Kühlplatte 46 und der Deckelheizer 44 derart geregelt, dass der Deckelheizer 44 auf einer Temperatur oberhalb der Schmelztemperatur des zu verarbeitenden Siliziums gehalten wird und der Tiegelboden auf eine Temperatur knapp unterhalb der Schmelztemperatur des zu verarbeitenden Siliziums gebracht wird. Dies führt zunächst zur Auskristallisation von Silizium am Boden des Schmelztiegels 41. Da sich die Kühlplatte 46 über die gesamte Fläche des Bodens des Schmelztiegels 41 erstreckt, kristallisiert das Silizium nicht nur im Zentrum sondern am gesamten Boden des Tiegels in Form einer Vielzahl von Kristalliten aus.

Anschließend wird über die Wärmeisolationsanordnung 47 Wärme wie nachfolgend beschrieben abgeführt, um die Temperatur des Bodens des Schmelztiegels 41 immer mehr zu reduzieren. Durch geeignete Regelung des Mantelheizers 45 wird in dem Schmelztiegel 41 ein gleichmäßiger Temperaturgradient in vertikaler Richtung ausgebildet. Zu diesem Zweck kann der Mantelheizer 45 derart ausgebildet sein, wie in der deutschen Patentanmeldung DE 10 2006 017 621 A1 der Anmelderin ausführlich beschrieben, deren Inhalt im Wege der Bezugnahme ausdrücklich mit beinhaltet sei.

Um möglichst viel Wärme über die den Tiegelboden abzuführen, wird die Wärmeisolationsanordnung 47 mittels der Hubstange 49 in Anlage zu dem Tiegelboden gebracht und vollständig komprimiert. Durch Wärmeleitung durch die plattenförmigen Körper der als Wärmeisolationsanordnung gemäß der vorliegenden Erfindung ausgebildeten Bodenplatte 47 wird so effizient Wärme abtransportiert. Dies kann durch aktives Kühlen mittels der Kühlplatte 46 unterstützt werden.

Die Wärmeisolationsanordnung kann eine kleinere Fläche als der Tiegelboden aufweisen und das Temperaturfeld kann durch zusätzliche Bodenheizer beeinflusst werden

Um andererseits eine möglichst hohe Wärmeisolation am Boden des Schmelztiegels 41 während der Phase des Schmelzens des Siliziumrohmaterials zu erzielen, wird die Kühlplatte 46 durch Verstellen der Hubstange 49 nach unten und weg von dem Schmelztiegel 41 bewegt, sodass sämtliche plattenförmigen Körper der als Wärmeisolationsanordnung gemäß der vorliegenden Erfindung ausgebildeten Bodenplatte 47 parallel und beabstandet zueinander angeordnet sind, wie beispielsweise in der Fig. 2a bzw. 4a dargestellt. Somit kann durch Verstellen der Hubstange 49 das Wärmeisolationsvermögen am Boden des Schmelztiegels in einfacher Weise zwischen einem optimal wärmeleitenden Zustand (während des Auskristallisierens: Abtransport von Wärme überwiegend durch Wärmeleitung) und einem optimal wärmeisolierenden Zustand (während des Aufschmelzens des Siliziums: Abtransport von Wärme überwiegend durch Strahlung) geschaltet werden.

Wenngleich vorstehend ausgeführt wurde, dass die Wärmeisolationsanordnung unterhalb des Schmelztiegels angeordnet ist, wird dem Fachmann ohne weiteres ersichtlich sein, dass die erfindungsgemäße Wärmeisolationsanordnung selbstverständlich auch an anderen Bereichen eines Schmelztiegels angeordnet sein kann, beispielsweise als Wärmeisolation an Seitenwänden oder oberhalb des Schmelztiegels.

Nachfolgend werden Ergebnisse von Simulationsrechnungen zu Ausführungsbeispielen der erfindungsgemäßen Wärmeisolationsanordnung vorgestellt.

## Vereinfachtes Rechenmodell

Wärme kann bei einer Wärmeisolationsanordnung, wie vorstehend beschrieben, durch Wärmeleitung, Strahlung und Konvektion übertragen werden. Hier werden aus Vereinfachungsgründen nur Wärmetransport durch Wärmeleitung und Strahlung berücksichtigt.

Für die durch Wärmeleitung abgeführte Wärmemenge P gilt:

$$P = \frac{\alpha}{s} A(T_{hei\beta} - T_{kalt}) \qquad (1)$$

dabei sind a Wärmeleitung des Materials, A die Querschnittsfläche und s die Dicke des Materials. Für die Wärmestrahlung gilt:

$$P = \varepsilon\sigma * A(T_{hei\beta}^4 - T_{kalt}^4) \qquad (2)$$

dabei ist $\varepsilon$ die Emissivität des Materials, $\sigma$ eine Konstante und A die strahlende bzw. absorbierende Fläche.

Für ein einfaches Modell lassen sich nun die Wärmeflüsse Pi durch jede Schicht der Wänneisolationsanordnung bestimmen und dann mit Hilfe der Simulation die Temperaturen an den Materialgrenzen so wählen, dass der Wärmestrom durch alle Schichten gleich ist. Auf diese Weise wurden die Temperaturen weiter unten ermittelt. Dieses Vorgehen berücksichtigt den Wärmeaustausch innerhalb der Ebene der Strahlungsschilde nicht, sondern berücksichtig nur den Wärmetransport senkrecht dazu, was bei der Verwendung von Stützen zu einer geringen Überschätzung des Wärmeabflusses führt.

Die folgenden Randbedingungen wurden für einen Vergleichsaufbau gewählt: Auf einer wassergekühlten Cu Platte liegen zwei Graphitplatten (R6510) der Dicke 50mm und 75mm und eine Lage Grafitfilz der Dicke 10 mm. Das Loch für das Pyrometer in der Mitte der Platten wird in der Berechnung nicht berücksichtigt. Die Tiegelunterseite hat eine Temperatur von ca. 1500°C. Nimmt man an, dass diese auf die Oberseite des Grafitfilzes abstrahlt und die Grafitplatten darunter die Wärme über Wärmeleitung an die wassergekühlte Cu-Platte (Temperatur 30°C) abgeben, so erhält man eine Wärmeabfuhr von ca. 4-5kW. Eine Zusammenstellung der Werte zeigt die Tabelle 1:

Tabelle 1 Rechnung für einen realen Vergleichsaufbau mit 2 Lagen Graphit und einer Lage Graphitfilz

| Kommentar | Abstand | Leistung | Temperatur | |
|---|---|---|---|---|
| | in m | in W | K | °C |
| Tiegelunterseite | 0 | | 1773 | 1500 |
| strahlt auf Oberseite Filz | 1,00E-01 | 4,83E+03 | 1737,51651 | 1464,516514 |
| Wärmeleitung durch Filz | 1,10E-01 | 4,83E+03 | 343,664247 | 70,66424745 |
| Randbedingung Cu Platte | 2,35E-01 | 4,83E+03 | 300 | 27 |

Es können in dieser Anordnung nur ca. 4-5 kW Wärme abgebührt werden, wobei die Temperatur über den Graphitfilz stark abfällt. Dieser verhindert somit einen effizienten Abtransport von Wärme dann, wenn die Schmelze in dem Schmelztiegel gerichtet erstarrt werden soll.

## Berechnung für ein Vergleichsbeispiel mit 13 Strahlungsschilden

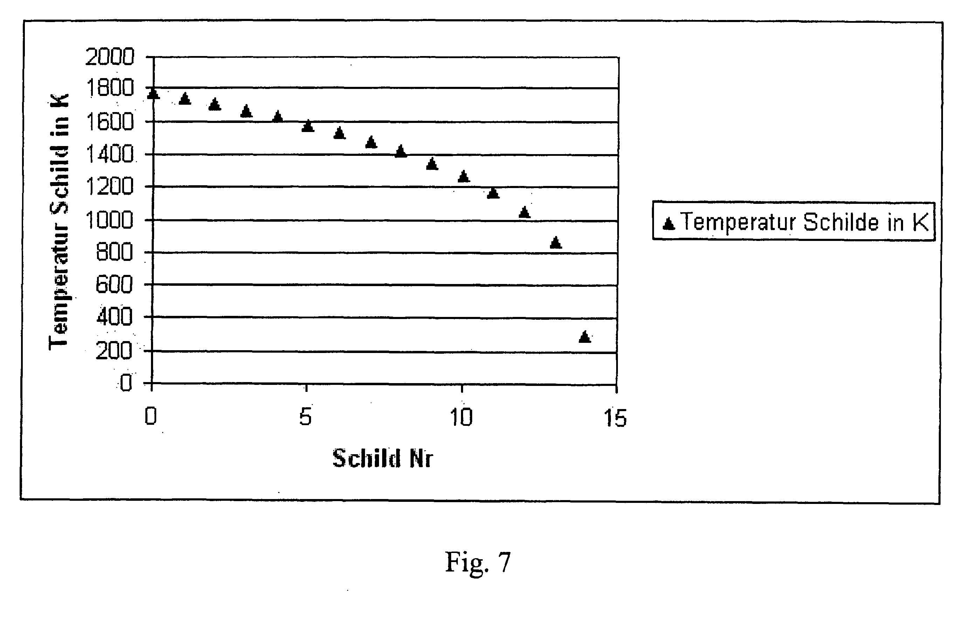

Durch die parallele Anordnung von 13 Scheiben (ohne elastische Wärmedämmeinlagen) mit Zwischenraum quer zur Wärmeflussrichtung lässt sich der Wärmetransport durch Strahlung beeinflussen. Eine Beispielrechnung berücksichtigt die Wärmestrahlung zwischen den Strahlungsschilden und Wärmeleitung über die Strahlungsschilde (von oben nach unten) und Wärmeleitung im Argon zwischen den Strahlungsschilden. Der Einfluss von Halterungen für die Strahlungsschilde ist vernachlässigt. Die Ergebnisse sind in der Tabelle 2 und in der Fig. 7 zusammengefasst. Es ergibt sich bei 13 Strahlungsschilden eine Wärmeabführung von ca.4,5 kW.

Tabelle 2: Ergebnis der Berechnung einer Wänneisolationsanordnung mit insgesamt 13 Strahlungsschilden. Die Temperaturen der mittleren Spalte wurden so gewählt, dass die zwischen den Strahlungsschilden ausgetauschten Wärmemengen gleich sind.

| Schild Nr | Leistung | Temperatur Schilde in K | |
|---|---|---|---|
| Schilde | in W | Oberseite | Unterseite |
| 0 | | 1773 | 1773 |
| 1 | 4,46E+03 | 1740,80732 | 1738,341048 |

(fortgesetzt)

| Schild Nr | Leistung | Temperatur Schilde in K | |
|---|---|---|---|
| Schilde | in W | Oberseite | Unterseite |
| 2 | 4,45E+03 | 1704,14207 | 1701,673441 |
| 3 | 4,45E+03 | 1665,16426 | 1662,69315 |
| 4 | 4,45E+03 | 1623,48658 | 1621,01289 |
| 5 | 4,45E+03 | 1578,60597 | 1576,129508 |
| 6 | 4,45E+03 | 1529,85501 | 1527,375653 |
| 7 | 4,45E+03 | 1476,3229 | 1473,840868 |
| 8 | 4,45E+03 | 1416,7161 | 1414,232157 |
| 9 | 4,45E+03 | 1349,09434 | 1346,610004 |
| 10 | 4,45E+03 | 1270,32521 | 1267,843224 |
| 11 | 4,45E+03 | 1174,78861 | 1172,313908 |
| 12 | 4,45E+03 | 1050,60802 | 1048,150971 |
| 13 | 4,45E+03 | 863,240316 | 8,61E+02 |
| 14 | 4,45E+03 | 300 | |

Wie die Fig. 7 zeigt, ist die Temperaturbelastung der obersten Strahlungsschilde sehr hoch, weshalb für die Strahlungsschilde in jedem Fall hochtemperaturfeste Materialien, wie beispielsweise Graphit, verwendet werden sollten. Dies gilt auch für deren Halterungen. Allerdings ergibt sich über die Strahlungsschilde ein erheblicher Abfall der Temperatur.

**Berechnung für ein erstes Ausführungsbeispiel**

Für eine Wärmeisolationsanordnung mit insgesamt 5 Strahlungsschilden und elastischer Wärmedämmeinlage aus einem Graphitfilz, wie diese in den Figuren 4a und 4b gezeigt ist, wurden zur Berechnung die folgenden Parameter verwendet, wie diese in der Tabelle 3 zusammengefasst sind:

Tabelle 3: Parameter einer erfindungsgemäßen Wärmeisolationsanordnung, die der Berechnung zugrunde lagen

| | Bezeichnung | | |
|---|---|---|---|
| Abstand Tiegel-1.Schild | | 1.00E-01 | m |
| Dicke Filz | b | 1,00E-02 | m |
| Dicke Schilde | a | 2,00E-02 | m |
| Fläche Wärmebrücken | WB | 3,80E-02 | m^2 |
| Abstand Wärmebrücken unbelastet | e | 2,00E-03 | m |
| Aufbau Wärmebrücken | u | 8,00E-03 | |

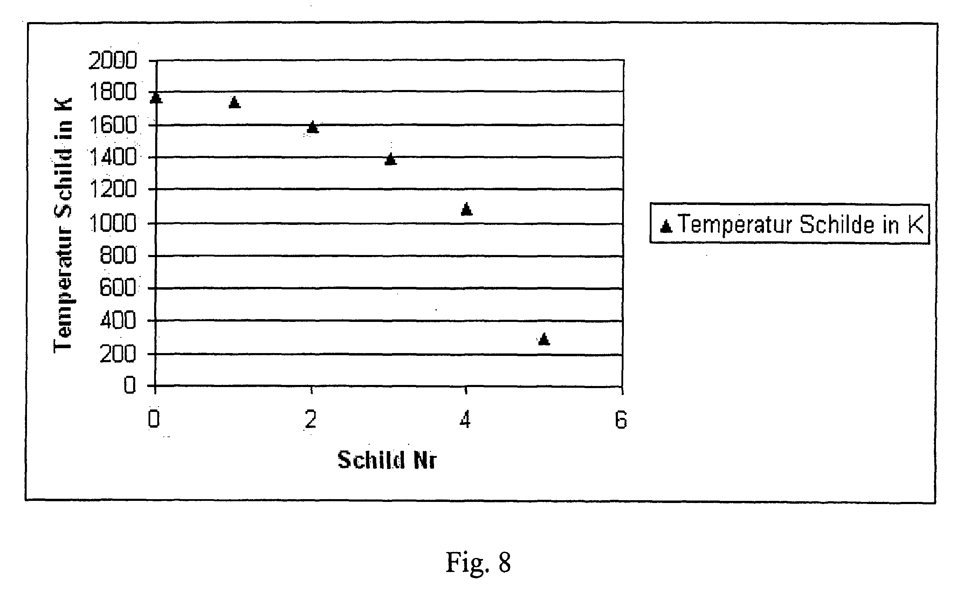

Das vereinfachte Modell, wie oben ausgeführt, ergab für diese Wärmeisolationsanordnung bei einer Belastung nur durch das Eigengewicht der Strahlungsschilde einen Wärmestrom von ca. 5 kW. Die Ergebnisse sind in der Fig. 8 und in der Tabelle 4 zusammengefasst.

Tabelle 4: Ergebnis der Berechnung bei Belastung der Strahlungsschilde nur aufgrund ihres Eigengewichts

| Schild Nr | Leistung | Temperatur Schilde in K | |
|---|---|---|---|
| Schilde | in W | Oberseite | Unterseite |
| 0 | | 1713 | 1773 |

(fortgesetzt)

| Schild Nr | Leistung | Temperatur Schilde in K | |
|---|---|---|---|
| Schilde | in W | Oberseite | Unterseite |
| 1 | 5,18E+03 | 1734,85528 | 1723,390117 |
| 2 | 5,18E+03 | 1585,38938 | 1573,909617 |
| 3 | 5,18E+03 | 1389,33188 | 1377,79998 |
| 4 | 5,18E+03 | 1037,30871 | 1075,754117 |
| 5 | 5,18E+03 | 300 | |

Die Fig. 8 zeigt den gleichen Abfall der Temperatur der Strahlungsschilde, wie dieser bereits in der Fig. 7 dargestellt ist.

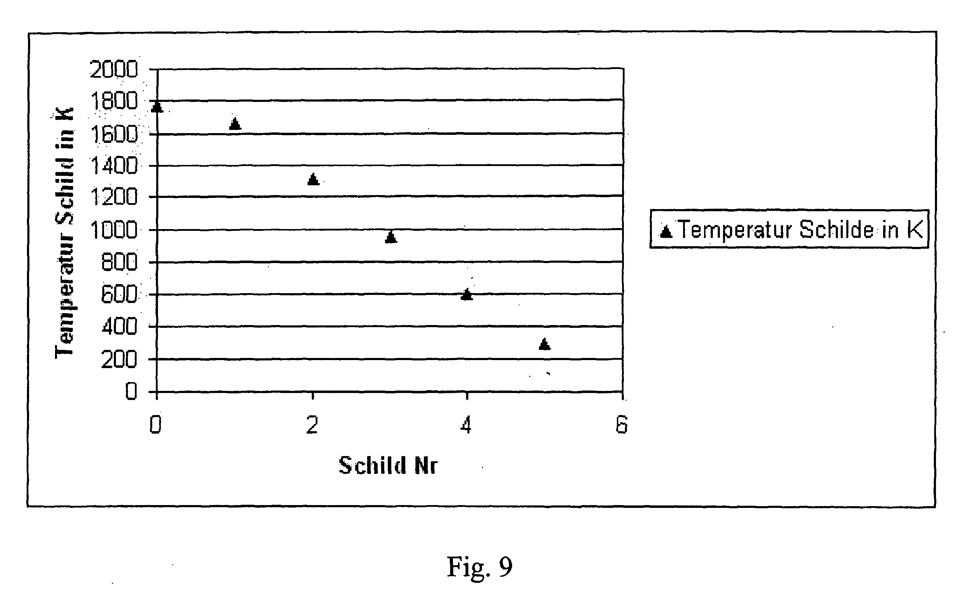

Bei einer Belastung mit einer Gewichtskraft von zusätzlich 500N ergab sich ein erheblich höherer Wärmestrom, nämlich von ca. 25 kW. Ergebnisse sind in der Fig. 9 und in der Tabelle 5 zusammengefasst.

Tabelle 5: Ergebnis der Berechnung bei Belastung der Strahlungsschilde mit zusätzlicher Anpresskraft von 500N

| Schild Nr | Leistung | Temperatur Schilde in K | |
|---|---|---|---|
| Schilde | in W | Oberseite | Unterseite |
| 0 | | 1773 | 1773 |
| 1 | 2,69E+04 | 1656,17113 | 1,60E+03 |
| 2 | 2,69E+04 | 1306,28118 | 1,25E+03 |
| 3 | 2,69E+04 | 951,1645 | 891,2660767 |
| 4 | 2,69E-04 | 605,971695 | 548,8300754 |
| 5 | 2,69E+04 | 300 | |

Die Fig. 9 zeigt eine in etwa lineare Abhängigkeit der Temperatur der Strahlungsschilde, wie diese für eine Wärmeabfuhr durch Wärmeleitung typisch ist.

**Berechnung für ein zweites Ausführungsbeispiel**

Nachfolgend werden die Ergebnisse einer Berechnung der Wärmeisolationsanordnung gemäß der Fig. 5a, vorgestellt, die ohne elastische Werkstoffe auskommt. Dafür sind die einzelnen Strahlungsschilde mit drei zusätzlichen Löchern versehen, die mit der Entfernung zur Cu-Kühlplatte 46 (vgl. Fig. 5a) in ihrem Durchmesser abnehmen. So hat z.B. die untere Platte 2 Löcher mit einem Durchmesser von 41 mm, die nächste Platte 2 Löcher mit einem Durchmesser von 39 mm, usw.. Diese Löcher sind in den Strahlungsschilden so angebracht, dass sie koaxial übereinander liegen. Die Stützen sind so gefertigt, dass ihr Durchmesser stufenförmig von unten nach oben abnimmt, und zwar so, dass auf jeder Stufe ein Strahlungsschild aufliegt. So haben die Stützen z.B. unten einen Durchmesser von 42 mm, um das unterste Strahlungsschild zu tragen, und ca. 2 mm höher einen Durchmesser von 40 mm, um das zweite Strahlungsschild zu tragen usw. Der kleinste Durchmesser beträgt demnach 10 mm. Die Durchmesseränderungen der Stützen können stufenweise sein, oder innerhalb eines Übergangsbereichs von ca. 1mm kontinuierlich sein. Ein kontinuierlicher Übergang bietet weniger thermischen Einfluss und verhindert, dass Platten beim Absenken an dem Übergang hängen bleiben.

Solche Stützen leiten ebenfalls die Wärme und sind in der Energiebilanz zu berücksichtigen. Es ist vorteilhaft die Stützen aus einem weniger wärmeleitenden Material zu fertigen, beispielsweise aus Graphit R6300.

Die Rechnungen zeigen, dass es von großem Vorteil ist, die Stützen gegen das Gehäuse und die Cu-Platte mittel Grafitfilz zu isolieren. Dies wird bei der Berechnung berücksichtigt, indem das unterste Element der Stütze die Wärmeleitung des Grafitfilzes zugeordnet bekommt. Um unter 5kW Wärmeabfuhr zu bleiben, ist es ebenfalls notwendig, mit insgesamt 15 Strahlungsschilden zu arbeiten.

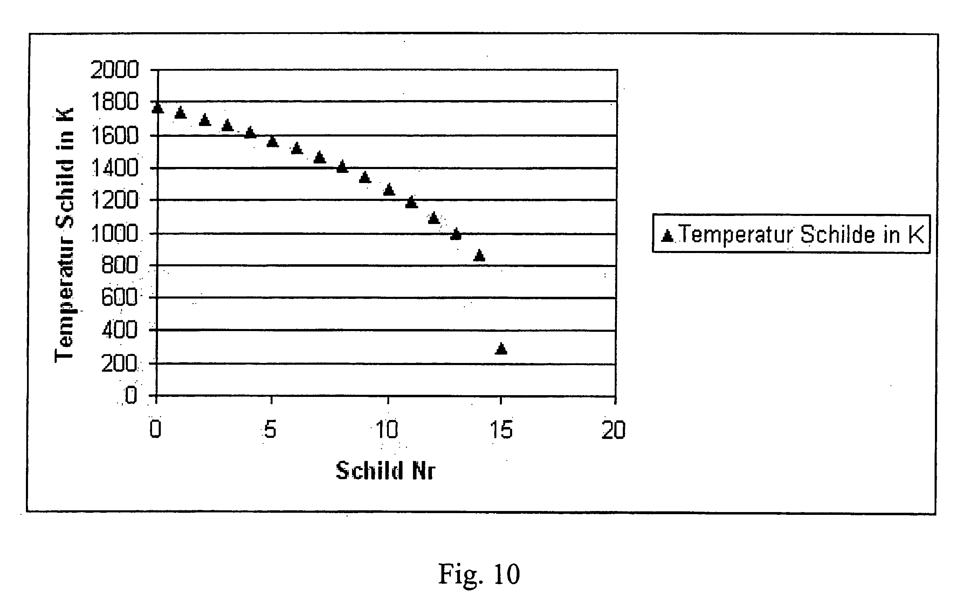

Die Tabelle 6 und die Fig. 10 fassen die Ergebnis der Rechnungen mit drei Stützstreben zusammen, die unten 40 mm Durchmesser und oben 10 mm Durchmesser haben. Die Stützen sind ab einem Außendurchmesser von 20 mm innen hohl ausgeführt, mit einer Wanddicke von 10mm. Es wird eine ideale Wärmeankopplung der Schilde an die Stützen angenommen, was im Ergebnis dazu führt, dass die Wärmeabfuhr in der Rechnung etwas überschätzt wird.

Tabelle 6: Ergebnis der Berechnung für die Wärmeisolationsanordnung gemäß der Fig. 5a mit insgesamt 5 Strahlungsschilden

| Schild Nr | Leistung | Temperatur Schilde in K | |
|---|---|---|---|
| Schilde | in W | Oberseite | Unterseite |
| 0 | | 1773 | 1773 |
| 1 | 4,92E+03 | 1738,41135 | 1735,688193 |
| 2 | 4,92E+03 | 1699,21181 | 1696,486555 |
| 3 | 4,91E+03 | 1657,96491 | 1655,238261 |
| 4 | 4,91E+03 | 1614,49797 | 1611,770889 |
| 5 | 4,90E+03 | 1567,6215 | 1564,894947 |
| 6 | 4,89E±03 | 1517,40137 | 1514,676265 |
| 7 | 4,88E+03 | 1463,25242 | 1460,529827 |
| 8 | 4,87E+03 | 1404,41878 | 1401,699972 |
| 9 | 4,86E+03 | 1339,90803 | 1337,194723 |
| 10 | 4,85E+03 | 1268,39782 | 1265,692628 |
| 11 | 4,84E+03 | 1188,11037 | 1185,417486 |
| 12 | 4,84E+03 | 1096,67343 | 1093,999975 |
| 13 | 4,83E+03 | 991,090362 | 988,4485655 |
| 14 | 4,83E+03 | 868,287246 | 865,6981015 |
| 15 | 4,83E+03 | 300 | |

Der Fig. 10 kann man entnehmen, dass sich im Zustand gemäß der Fig. 5a, wenn die Strahlungsschilde nicht unmittelbar aufeinander liegen bzw. einander nicht vollflächig berühren, der typische Temperaturverlauf für Wärnleabtransport durch Wärmestrahlung einstellt.

Eine Vergleichsrechnung für den zweiten Zustand der Wärmeisolationsanordnung gemäß der Fig. 5a, wenn die Strahlungsschilde unmittelbar aufeinander liegen bzw. einander vollflächig berühren, ergab eine lineare Abhängigkeit der Temperatur der Strahlungsschilde, die für einen Wärmeabtransport aufgrund von Wärmeleitung typisch ist. Gleichzeitig ergab die Rechnung, dass der Wärmeabtransport in diesem Zustand erheblich höher ist, als dann, wenn die Strahlungsschilde zueinander beabstandet sind.

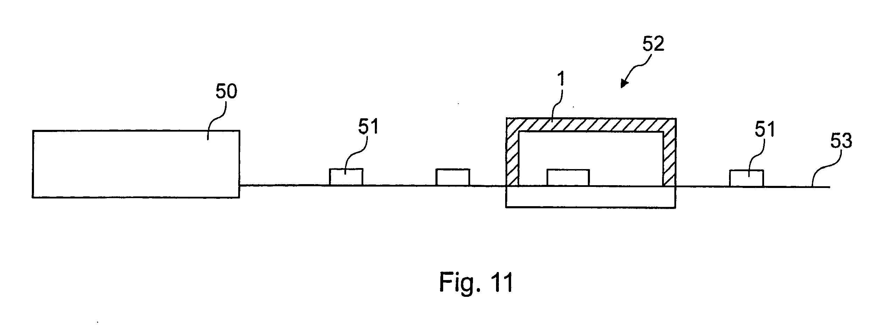

Anhand der Fig. 11 wird nachfolgend eine weitere bevorzugte Verwendung der erfindungsgemäßen Wärmeisolationsanordnung bei einer Anlage zur Herstellung von Glaskörpern beschrieben.

In der Glasindustrie ist es üblich, Glaskörper, wie beispielsweise Glasbänder oder Glasartikel, nach der Formgebung durch Kühlung in Durchlauföfen unter kontrollierten Bedingungen langsam abzukühlen. Bei der Auslegung solcher Öfen wird normalerweise die Wärmeisolation so gewählt, dass mit geeigneten Heizeinrichtungen ein für das Glas günstiger Temperatur-Zeit-Verlauf eingestellt werden kann. Die dafür benötigte Wärme wird in der Regel über elektrische Heizer zugeführt. Bei Durchsatzschwankungen schwankt die durch das heiße Glas eingebrachte Wärmemenge in den Kühlofen. So bringt das heiße Glas bei größerem Durchsatz mehr Wärme ein als bei geringem Durchsatz. Diese Schwankungen werden üblicherweise durch Regelung der elektrischen Heizer bzw. deren Heizleistung kompensiert. Der Ofen wird üblicherweise deshalb so ausgelegt, dass auch bei hohen Durchsätzen eine elektrische Zusatzheizung notwendig ist. Dies wird durch eine entsprechend schwach dimensionierte Dämmung der Ofenwände erreicht, was aus unter energetischen Gesichtspunkten nachteilig ist.

Um nun den Ofen besser an Durchsatzschwankungen anzupassen und dabei mit weniger elektrischer Heizenergie auszukommen, kann durch Verwendung einer erfindungsgemäßen Wärmeisolationsanordnung als Isolationsmaterial eines solchen Ofens das Wärmeisolationsvermögen dessen Ofenwand geeignet variiert werden. In Bereichen, in denen eine größere Wärmeabgabe an die Umgebung nötig ist, um die von dem Prozess benötigte Temperatur zu erhalten, wird die Wärmeisolationsanordnung so eingestellt, dass die Platten teilweise in Kontakt zueinander gebracht werden. In Bereichen, in denen eine geringere Wärmeabgabe an die Umgebung notwendig ist, um die vom Prozess benötigte Temperatur zu erreichen, wird die Wärmeisolationsanordnung so eingestellt, dass die Platten keinen Kontakt mehr zueinander haben, der Wärmetransport also überwiegend durch Wärmestrahlung erfolgen muss.

Eine solche Anlage ist in der Fig. 11 schematisch dargestellt, die eine Anlage 50 zur Herstellung von Glasformkörpers 51 darstellt, die mittels einer Fördereinrichtung 53, beispielsweise eines Förderbands oder eines Kettenförderers, durch einen Durchlaufofen 52 transportiert werden, ein welchem nicht dargestellt Heizeinrichtungen, beispielsweise Gasbrenner oder elektrische Heizeinrichtungen, vorgesehen sind, die für eine kontrollierte Abkühlung entsprechend einem vorgegebenen Temperatur-Zeit-Profil sorgen. Gemäß der Fig. 11 ist die Wand des Durchlaufofens 52 aus einem Material ausgebildet, dass eine Wärmeisolationsanordnung 1 mit variablem Wärmeisolationsvemiögen gemäß der vorliegenden Erfindung beinhaltet.

Beim Studium der vorstehenden Beschreibung wird dem Fachmann ohne weiteres ersichtlich sein, dass die erfindungsgemäß Wärmeisolationsanordnung für beliebige andere Einsatzzwecke als vorstehend offenbart in entsprechender Weise eingesetzt werden kann, insbesondere wenn eine veränderliche Wärmeisolationswirkung gewünscht ist. Wenngleich die Erfindung vorstehend anhand von speziellen Ausführungsbeispielen beschrieben wurde, sei darauf hingewiesen, dass dem Fachmann beim Studium der vorstehenden Beschreibung zahlreiche weitere Modifikationen und Ausführungsformen ersichtlich sein werden. Der Schutzbereich der beigefügten Patentansprüche soll sich deshalb auf solche weiteren Modifikationen und Ausführungsformen mit erstrecken, sofern diese von dem allgemeinen Lösungsgedanken Gebrauch machen und unter den Schutzbereich der beigefügten Patentansprüche fallen.

**Bezugszeichenliste**

| | |
|---|---|
| 1 | Wärmeisolationsanordnung |
| 2 | Strahlungsschild |
| 3 | Platte/Strahlungsschild |
| 4 | Ausnehmung |
| 5 | Elastische Wärmedämmeinlage |
| 6 | Federelement |
| 7 | Wärmedämmeinlage |
| 8, 8' | Spalt |
| 10 | Äußere Ausnehmung |
| 11 | Umlaufender Vorsprung |
| 12 | Umlaufender Vorsprung / Abstandshalter |
| 13 | zentrale Ausnehmung |
| 14 | äußere elastische Wärmedämmeinlage |
| 15 | innere elastische Wärmedämmeinlage |
| 20 | Gestufte Führungsstange |
| 21 | Erste Stufe |
| 22 | Zweite Stufe |
| 23 | Dritte Stufe |
| 24 | Vierte Stufe |
| 25 | Fünfte Stufe |
| 26 | Schaft |
| 30 | Führungsaufnahme |
| 31 | Erste Stufe |
| 32 | Zweite Stufe |
| 33 | Dritte Stufe |
| 34 | Vierte Stufe |
| 35 | Fünfte Stufe |
| 36 | Boden |
| 37 | oberer Rand |
| 38 | Führungsstange |
| 40 | Kristallisationsanlage |
| 41 | Tiegel |
| 42 | Graphitbehälter |
| 43 | Schmelze |
| 44 | Deckelheizer |
| 45 | Mantelheizer |
| 46 | Kühlplatte |

47    Wämeisolationsanordnung
48    Wärmeisolation
49    Verstelleinrichtung
50    Glasformkörper-Herstellungsanlage
51    Glasformkörper
52    Kühlofen
53    Fördereinrichtung

**Patentansprüche**

1.  Wärmeisolationsanordnung mit variablem Wärmeisolationsvermögen, umfassend
    eine Mehrzahl von plattenförmigen Körpern (3), die entlang einer vorgegebenen Richtung aufeinander folgend angeordnet sind, und
    eine zugeordnete Verstelleinrichtung zum Verstellen von zumindest einem der plattenförmigen Körper (3) in der vorgegebenen Richtung, wobei
    zumindest eine Teilgruppe der plattenförmigen Körper (3) in einer ersten Stellung in der vorgegebenen Richtung zueinander beabstandet angeordnet sind, und
    mittels der Verstelleinrichtung der Abstand zumindest zwischen den plattenförmigen Körpern der vorgenannten Teilgruppe so veränderbar ist, dass diese vollflächig aneinander anliegen, um das Wärmeisolationsvermögen der Wärmeisolationsmordnung zu verändern, **dadurch gekennzeichnet, dass** in einer eine Ebene aufspannenden Oberfläche eines jeweiligen plattenförmigen Körpers (3) zumindest eine Ausnehmung (4; 10, 13) ausgebildet ist, um einen zugeordneten Wärmedämmkörper (5; 7; 14, 15) aufzunehmen.

2.  Wärmeisolationsanordnung nach Anspruch 1, wobei der zugeordnete Wärmedämmakörper (5; 7; 14, 15) korrespondierend zur Ausnehmung (4; 10, 13) ausgebildet ist, wobei der Wärmedämmkörper (5; 7) in einem Normalzustand jeweils über die Oberfläche hinausragt und durch Kraftbeaufschlagung senkrecht zur Oberfläche elastisch komprimierbar oder rückstellbar ist, bis dieser jeweils bündig mit der Oberfläche abschließt oder korrespondierend zur Ausnehmung (4; 10, 13) ausgebildet ist und auf einem Boden der jeweiligen Ausnehmung (10, 13) zumindest ein Vorsprung (11) ausgebildet ist, der an dem zugeordneten Wärmedämmkörper (14, 15) anliegt oder in diesen eingedrückt ist, wobei der Wärmedämmkörper in einem Normalzustand über die Oberfläche des plattenförmigen Körpers (3) hinausragt.

3.  Wärmeisolationsanordnung nach Anspruch 2, wobei der jeweilige Wärmedämmkörper (14, 15) so ausgelegt ist, dass in dem Normalzustand zwischen einem die jeweilige Ausnehmung (10; 13) seitlich begrenzenden Rand (12) und dem benachbarten plattenförmigen Körper (3) in der vorgegebenen Richtung ein Spalt (8') ausgebildet ist.

4.  Wärmeisolationsanordnung nach einem der vorhergehenden Ansprüche, wobei der jeweilige Wärmedämmkörper (5) ein elastisch verformbarer Filz aus einem hochtemperaturfesten Material ist.

5.  Wärmeisolationsanordnung nach Anspruch 1, wobei der jeweilige Wärmedämmkörper (5; 7) aus einem in elastischem Material gebildet ist und in einem Normalzustand jeweils nicht über die Oberfläche hinausragt.

6.  Wärmeisolationsanordnung nach einem der Ansprüche 1 bis 5, wobei die jeweilige Ausnehmung (4, 10) umlaufend und bevorzugt korrespondierend zur Querschnittsform des plattenförmigen Körpers (3) ausgebildet ist und die Ausnehmungen (4, 10) konzentrisch und kreisförmig ausgebildet sind, wobei in der jeweiligen Ausnehmung (4; 10, 13) ein elastisches Rückstellmittel (6) vorgesehen ist, um den zugeordneten Wärmedämmkörper (7) elastisch zurückzustellen, sodass dieser durch Kraftbeaufschlagung senkrecht zur Oberfläche elastisch rückstellbar ist, bis dieser bündig mit der Oberfläche abschließt, wobei das elastische Rückstellmittel (6) Graphitfolien und/oder Metallfolien bzw. -bleche umfasst.

7.  Wärmeisolationsanordnung nach einem der vorhergehenden Ansprüche, wobei die plattenförmigen Körper (3) vertikal übereinander angeordnet sind und die Verstelleinrichtung (49) den Abstand zwischen diesen durch Anheben und Absenken des untersten plattenförmigen Körpers (3) verändert und weiterhin ein Führungsmittel (22; 30) zum Führen der plattenförmigen Körper (3) in der vorgegebenen Richtung vorgesehen ist.

8.  Wärmeisolationsanordnung nach einem der vorhergehenden Ansprüche, wobei die plattenförmigen Körper (3) von zumindest einem Führungskörper (20; 30) geführt sind, der jeweils eine Mehrzahl von in der vorgegebenen Längsrichtung zueinander beabstandeten Stufen (21-25; 31-35) aufweist, deren Anzahl der Anzahl der plattenförmigen Körper (3) entspricht, wobei die jeweilige Höhe einer Stufe größer ist als die Dicke des zugeordneten plattenförmigen Körpers, wobei der jeweilige Führungskörper (20) zylinderförmig, kegelförmig oder ringförmig ausgebildet ist.

9. Wärmeisolationsanordnung nach einem der vorhergehenden Ansprüche, weiterhin umfassend Führungsstangen (38), die eng anliegend in Bohrungen der plattenförmigen Körper (3) aufgenommen sind und sich durch sämtliche plattenförmigen Körper (3) hindurch erstrecken, um diese zu führen.

10. Wärmeisolationsanordnung nach einem der vorhergehenden Ansprüche, wobei der unterste plattenförmige Körper eine kühlbare, insbesondere von einem Kühlmittel durchströmbare, Platte (46) ist.

11. Verwendung der Wärmeisolationsanordnung nach einem der vorhergehenden Ansprüche in einer Vorrichtung zum gerichteten Erstarren von Schmelzen in einem Tiegel, wobei die Wärmeisolationsanordnung (1; 47) unterhalb des Tiegels angeordnet ist und eine Wärmeabfuhr von dem Boden des Tiegels durch Ändern des Wärmeisolationsvermögens der Wärmeisolationsanordnung (1) azagepasst wird.

12. Verwendung nach Anspruch 11, wobei die Wärmeisolationsanordnung (1; 47) zwischen einem Boden des Tiegels und einer Kühlplatte (46) angeordnet ist und zwischen der Wärmeisolationsanordnung (1; 47) und der Kühlplatte (46) ein schmaler Spalt ausgebildet ist.

13. Vorrichtung zur Herstellung von ein- oder multikristallinen Materialien nach dem Vertical-Gradient-Freeze-Verfahren (VGF-Verfahren), mit einem feststehenden Tiegel (41) und einer Heizeinrichtung (44, 45), **gekennzeichnet durch** eine Wärmeisolationsanordnung (1; 47) nach einem der vorhergehenden Ansprüche, auf welcher der Tiegel abgestützt ist oder die unterhalb des Bodens des Tiegels angeordnet ist, wobei **durch** Ändern des Wärmeisolationsvermögens der Wärmeisolationsanordnung ein vertikaler Temperaturgradient in dem Tiegel veränderbar ist.

14. Vorrichtung nach Anspruch 13, wobei die Wärmeisolationsanordnung (1; 47) zwischen einem Boden des Tiegels und einer Kühlplatte (46) angeordnet ist und zwischen die Wärmeisolationsanordnung (1; 47) und der Kühlplatten (46) ein schmaler Spalt ausgebildet ist.

15. Verfahren zur Herstellung von ein- oder multikristallinen Materialien nach dem Vertical-Gradient-Freeze-Verfahren (VGF-Verfahren), in einem feststehenden Tiegel (41), wobei eine Heizeinrichtung das in den Tiegel eingebrachte Material schmilzt und die Schmelze durch Wärmeabfuhr in Richtung auf eine unterhalb des Tiegels angeordnete Kühlplatte (46) gerichtet erstarrt, wobei durch Ändern des Wärmeisolationsvermögens einer Wärmeisolationsanordnung (1) nach einem der Ansprüche 1 bis 10 ein vertikaler Temperaturgradient in dem Tiegel eingestellt wird.

16. Verwendung der Vorrichtung nach Anspruch 13 oder 14 oder des Verfahrens nach Anspruch 15 zur Herstellung von multikristallinem Silizium mittels eines Vertical-Gradient-Freeze-Kristallziehverfahrens (VGF), insbesondere als Ausgangsmaterial für photovoltaische Bauelemente.

17. Verwendung der Wärmeisolationsanordnung nach einem der Ansprüche 1 bis 10 als Wärmeisolationsmaterial in einem Ofen, wobei der Ofen bevorzugt ein Durchlaufofen ist, durch den Glaskörper nach einer Formgebung gefördert werden, um entsprechend einem vorbestimmten Temperatur-Zeit-Verlauf kontrolliert abzukühlen.

**Claims**

1. Thermal insulation assembly with variable thermal insulating capacity, comprising
a plurality of plate-shaped members (3), which are disposed along a predetermined direction sequently, and
an associated adjusting device for adjusting at least one of the plate-shaped members (3) in the predetermined direction, wherein
at least a subset of the plate-shaped members (3) are disposed spaced from one another in the predetermined direction in a first position, and
the distance at least between the plate-shaped members of said subset is varied by means of the adjusting device such that these abut each other over the entire surface to vary the thermal insulating capacity of the thermal insulation assembly, **characterized in that** at least one recess (4; 10; 13) is formed in a surface of a respective plate-shaped member (3) spanning plane for receiving an associated thermal insulating member (5; 14; 15; 7).

2. The thermal insulation assembly according to claim 1, wherein the associated thermal insulating member (5; 14; 15; 7) is formed corresponding to the recess (4; 10; 13), the thermal insulating member (5; 7) respectively extends beyond the surface in a normal state and can be compressed or reset resiliently through application of a force in a direction perpendicular to the surface until it is respectively flush with said surface or is formed corresponding to the recess (4; 10; 13) and at least one projection (11) is formed on a bottom of the respective recess (10, 13), which abuts to the associated thermal insulating member (14, 15) or is pushed into the latter, wherein the thermal insulating member extends beyond the surface of the plate-shaped member (3) in a normal state.

3. The thermal insulation assembly according to claim 2, wherein the respective thermal insulating member (14, 15) is configured such that a gap (8 ') is formed between an edge (12) laterally delimiting the respective recess (10; 13) and the plate-shaped member (3) adjacent in the predetermined direction in the normal state.

4. The thermal insulation assembly according to any of the preceding claims, wherein the respective thermal insulating member (5) is an elastically deformable felt made of a refractory material.

5. The thermal insulation assembly according to claim 1, wherein the respective thermal insulating member (5; 7) is formed of an inelastic material and respectively does not extend beyond the surface in a normal state.

6. The thermal insulation assembly according to any of claims 1 to 5, wherein the respective recess (4, 10) is formed circumferentially and preferably corresponding to the cross-sectional shape of the plate-shaped member (3) and the recesses (4, 10) are formed concentric and circular, wherein a resilient resetting means (6) is provided in the respective recess (4; 10; 13) for resiliently resetting the associated thermal insulating member (7) so that it is resiliently reset through application of a force perpendicularly to said surface until it is flush with said surface, wherein the elastic resetting means (6) comprises graphite foils and/or metallic films or metal sheets.

7. The thermal insulation assembly according to any of the preceding claims, wherein the plate-shaped members (3) are arranged vertically one above the other and the adjusting device (49) varies the distance between them by raising and lowering of the lowermost plate-shaped member (3), and further wherein a guide means (22; 30) for guiding the plate-shaped member (3) in the predetermined direction is provided.

8. The thermal insulation assembly according to any of the preceding claims, wherein the plate-shaped members (3) are guided by at least one guiding member (20, 30), each of which comprises a plurality of stages (21-25; 31-35) spaced from each other in the predetermined longitudinally direction, the number of which corresponds to the number of the plate-shaped members (3), wherein the respective height of a stage is greater than the thickness of the associated plate-shaped member, wherein the respective guiding member (20) is cylindrical, conical or annular.

9. The thermal insulation assembly according to any of the preceding claims, further comprising guiding rods (38), which are received snugly in bores in the plate-shaped member (3) and extend through all the plate-shaped members (3) for guiding them.

10. The thermal insulation assembly according to any of the preceding claims, wherein the lowermost plate-shaped member is a coolable plate (46), in particular a plate through which a coolant can flow.

11. A use of the thermal insulation assembly according to any of the preceding claims in an apparatus for the directional solidification of melt in a crucible, wherein the thermal insulation assembly (1; 47) is disposed below the crucible and a heat dissipation from the bottom of the crucible is adjusted by varying the thermal insulating capacity of the thermal insulation assembly (1).

12. The use according to claim 11, wherein the thermal insulation assembly (1; 47) is disposed between a bottom of the crucible and a cooling plate (46) and wherein a narrow gap is formed between the thermal insulation assembly (1; 47) and the cooling plate (46).

13. An apparatus for producing mono-crystalline or multi-crystalline materials by the vertical-gradient-freeze-method (VGF method), comprising a fixed crucible (41) and a heating device (44, 45) **characterized by** a thermal insulation assembly (1; 47) according to any of the preceding claims on which the crucible is supported or which is disposed below the bottom of the crucible, wherein a vertical temperature gradient in the crucible is varied by varying the thermal insulating capacity of the thermal insulation assembly.

**14.** The apparatus of claim 13, wherein the thermal insulation assembly (1; 47) is disposed between a bottom of the crucible and a cooling plate (46) and wherein a narrow gap is formed between thermal insulation assembly (1; 47) and the cooling plate (46).

**15.** A method for producing mono-crystalline or multi-crystalline materials by the vertical-gradient-freeze-method (VGF method) in a fixed crucible (41), wherein a heating device melts the material introduced into the crucible and the melt is directionally solidified by heat dissipation in a direction toward a cooling plate (46) disposed below the crucible, wherein a vertical temperature gradient in the crucible is adjusted by varying the thermal insulating capacity of the thermal insulation assembly (1) according to any of claims 1 to 10.

**16.** A use of the apparatus according to claim 13 or 14 or of the method according to claim 15 for the production of multi-crystalline silicon by means of a vertical-gradient-freeze crystal growing method (VGF), in particular as a starting material for photovoltaic components.

**17.** A use of the thermal insulation assembly according to any of claims 1 to 10 as thermal insulating material in a furnace, wherein the furnace is a continuous furnace through which glass articles are conveyed after a shaping process in order to cool in a controllable manner according to a predetermined temperature-time profile.

**Revendications**

**1.** Système d'isolation thermique présentant une capacité variable d'isolation thermique, comprenant :

une pluralité de corps (3) en forme de plaque qui sont disposés successivement le long d'une direction prédéterminée ; et
un dispositif de réglage associé pour régler au moins l'un des corps (3) en forme de plaque dans la direction prédéterminée, dans lequel
au moins un sous ensemble de corps (3) en forme de plaque sont espacés les uns des autres dans une première position suivant la direction prédéterminée, et
la distance minimale entre les corps en forme de plaque dudit sous-ensemble varie au moyen du dispositif de réglage de telle manière que ceux-ci aboutent les uns les autres sur la surface complète pour modifier la capacité d'isolation thermique du système d'isolation thermique, **caractérisé en ce que** au moins un évidement (4 ; 10 ; 13) est formé dans le plan de surface d'un corps (3) respectif en forme de plaque afin de recevoir un corps isolant thermiquement associé (5 ; 14 ; 15 ; 7).

**2.** Le système d'isolation thermique selon la revendication 1, dans lequel le corps isolant thermiquement associé (5 ; 14 ; 15 ; 7) est formé de manière à correspondre à l'évidemment (4 ; 10 ; 13), le corps isolant thermiquement (5 ; 14 ; 15 ; 7) s'étendant au delà de la surface dans une configuration normale et pouvant être compressé ou relâché via l'application d'une force suivant une direction perpendiculaire à la surface jusqu'à l'affleurement respectif avec ladite surface ou est formé de manière à correspondre à l'évidemment (4 ; 10 ; 13) et au moins une projection (11) est formée sur le fond de l'évidemment respectif (10, 13), laquelle aboute contre le corps d'isolation thermique associé (14, 15) ou est poussé dans ce dernier, dans lequel le corps d'isolation thermique s'étend au-delà de la surface du corps (3) en forme de plaque dans la configuration normale.

**3.** Le système d'isolation thermique selon la revendication 2, dans lequel le corps isolant thermiquement (14, 15) est configuré de telle manière qu'un orifice (8') est formé entre un bord (12) délimitant latéralement l'évidemment respectif (10 ; 13) et le corps (3) en forme de plaque adjacent dans la direction prédéterminée de la configuration normale.

**4.** Le système d'isolation thermique selon l'une quelconque des revendications précédentes, dans lequel le corps isolant thermiquement respectif (5) est un feutre élastiquement déformable fait en matériau réfractaire.

**5.** Le système d'isolation thermique selon la revendication 1, dans lequel le corps isolant thermiquement respectif (5 ; 7) est formé d'un matériau non élastique et qui respectivement ne s'étend pas au-delà de la surface dans une configuration normale.

**6.** Le système d'isolation thermique selon l'une quelconque des revendications 1 à 6, dans lequel l'évidement respectif (4, 10) est formé d'une circonférence et correspond de préférence à la forme en coupe du corps (3) en forme de

**EP 2 304 365 B1**

plaque et les évidements (4, 10) sont formés de manière circulaire et concentrique, dans lequel un élément de rétablissement résilient (6) est disposé dans un évidement respectif (4 ; 10 ; 13) pour le rétablissement de manière résiliente du corps isolant thermiquement associé (7) de telle manière qu'il est restauré de manière résiliente au travers de l'application d'une force perpendiculaire à ladite surface jusqu'à l'affleurement avec ladite surface, dans lequel les moyens de rétablissement (6) comporte des feuilles de graphite et/ou des films ou feuilles métalliques.

7. Le système d'isolation thermique selon l'une quelconque des revendications précédentes, dans lequel les corps (3) en forme de plaque sont disposés verticalement les uns sur les autres et le dispositif de réglage (49) fait varier l'espacement entre eux par la levée ou la descente du corps (3) en forme de plaque de niveau le plus inférieur, et dans lequel en outre des moyens de guidage (22, 30) sont disposés pour le guidage du corps (3) en forme de plaque suivant la direction prédéterminée.

8. Le système d'isolation thermique selon l'une quelconque des revendications précédentes, dans lequel les corps (3) en forme de plaque sont guidés par au moins un élément de guidage (20, 30), chacun d'entre eux comprenant une pluralité d'étages (21-25 ; 31-35) disposés les uns par rapport aux autres dans la direction longitudinale prédéterminée, leur nombre correspondant au nombre de corps (3) en forme de plaque, dans lequel la hauteur respective d'un étage est plus élevée que l'épaisseur du corps en forme de plaque, l'élément de guidage respectif (20) étant cylindrique, conique ou annulaire.

9. Le système d'isolation thermique selon l'une quelconque des revendications précédentes, comprenant en outre des tiges de guidage (38), qui sont ajustés dans des orifices du corps (3) en forme de plaque et s'étendent au travers des corps (3) en forme de plaque pour leur guidage.

10. Le système d'isolation thermique selon l'une quelconque des revendications précédentes, dans lequel le corps en forme de plaque de niveau le plus inférieur est une plaque refroidissante (46), en particulier une plaque au travers de laquelle circule un fluide refroidissant.

11. Une utilisation d'un système d'isolation thermique selon l'une quelconque des revendications précédentes dans un appareil pour la solidification directionnelle d'une fusion dans un creuset, dans laquelle le système d'isolation thermique (1 ; 47) est disposé sous le creuset et une dissipation de chaleur depuis le bas du creuset est réglé au moyen de la variation de la capacité d'isolation thermique du système d'isolation thermique (1).

12. L'utilisation selon la revendication 11, dans laquelle le système d'isolation thermique (1 ; 47) est disposée entre le bas du creuset et une plaque de refroidissement (46) et dans laquelle un espacement étroit est formée entre le système d'isolation thermique (1 ; 47) et la plaque de refroidissement (46).

13. Un appareil de production de matériaux mono-cristallins ou poly cristallins au moyen du procédé de solidification à gradient vertical (VGF), comprenant un creuset fixe (41) et un dispositif de chauffe (44, 45), **caractérisé par** un système d'isolation thermique (1 ; 47) selon l'une quelconque des revendications précédentes sur lequel est disposé le creuset ou qui est disposé sous le bas du creuset, dans lequel un gradient de température vertical dans le creuset peut varier au moyen de la variation de la capacité d'isolation thermique du système d'isolation thermique.

14. Un appareil selon la revendication 13, dans lequel le système d'isolation thermique (1 ; 47) est disposé entre le bas du creuset et une plaque de refroidissement (46) et dans lequel un espacement étroit est formé entre le système d'isolation thermique (1 ; 47) et la plaque de refroidissement.

15. Une méthode de production de matériaux mono-cristallins ou poly cristallins au moyen du procédé de solidification à gradient vertical (VGF) au sein d'un creuset fixe (41), dans laquelle un dispositif de chauffe met en fusion les matériaux introduits dans le creuset et la fusion est solidifiée de manière directionnelle au moyen d'une dissipation de chaleur suivant une direction vers une plaque de refroidissement (46) disposée sous le creuset, dans laquelle un gradient de température vertical est réglé au moyen de la variation de la capacité d'isolation thermique du système d'isolation thermique (1) selon l'une quelconque des revendications 1 à 10.

16. Une utilisation de l'appareil selon la revendication 13 ou 14 ou de la méthode selon la revendication 15 pour la production de silicium multi cristallins au moyen du procédé de solidification à gradient vertical (VGF), en particulier comme matériau de départ de composants photovoltaiques.

17. Une utilisation du système d'isolation thermique selon l'une quelconque des revendications 1 à 10 comme matériau d'isolation pour four, dans laquelle le four est un four continu au travers duquel des articles de verres sont véhiculés à la suite d'un procédé de mise en forme jusqu'au refroidissement ajustable suivant un profil de baisse de température prédéterminé.

Fig. 1a

Fig. 1b

Fig. 2a

Fig. 2b

Fig. 3a

Fig. 3b

Fig. 3c

Fig. 4a

Fig. 4b

Fig. 5a

Fig. 5b

Fig. 5c

Fig. 5d

Fig. 6

Fig. 7

EP 2 304 365 B1

Fig. 8

Fig. 9

29

Fig. 10

Fig. 11

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2007148988 A1
- US 5849080 A
- DE 102006017621 A1
- DE 19855061 A1
- DE 10021585 C1
- EP 0996516 B1
- DE 29715846 A1
- DE 102005014051 A1
- DE 29715846 U1